(19) Europäisches Patentamt
European Patent Office
Office européen des brevets

(11) EP 2 941 473 B1

(12) **EUROPÄISCHE PATENTSCHRIFT**

(45) Veröffentlichungstag und Bekanntmachung des Hinweises auf die Patenterteilung:
**31.01.2018 Patentblatt 2018/05**

(21) Anmeldenummer: **13802886.5**

(22) Anmeldetag: **09.12.2013**

(51) Int Cl.:
***C09K 11/06*** (2006.01) ***H05B 33/14*** (2006.01)
***H05B 33/20*** (2006.01) ***H01L 51/00*** (2006.01)
***H01L 51/50*** (2006.01)

(86) Internationale Anmeldenummer:
**PCT/EP2013/003715**

(87) Internationale Veröffentlichungsnummer:
**WO 2014/106521 (10.07.2014 Gazette 2014/28)**

(54) **ELEKTRONISCHE VORRICHTUNG**
ELECTRONIC DEVICE
DISPOSITIF ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.01.2013 EP 13000015**

(43) Veröffentlichungstag der Anmeldung:
**11.11.2015 Patentblatt 2015/46**

(73) Patentinhaber: **Merck Patent GmbH**
**64293 Darmstadt (DE)**

(72) Erfinder:
- **KROEBER, Jonas Valentin**
  **60311 Frankfurt am Main (DE)**
- **VOGES, Frank**
  **67098 Bad Duerkheim (DE)**
- **PFLUMM, Christof**
  **64291 Darmstadt (DE)**

(56) Entgegenhaltungen:
**WO-A1-2010/006680** **WO-A1-2010/108579**
**DE-A1-102008 036 982** **US-A1- 2006 227 079**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 941 473 B1

Printed by Jouve, 75001 PARIS (FR)

## Beschreibung

Die vorliegende Anmeldung betrifft eine elektronische Vorrichtung mit Anode, Kathode und mindestens einer emittierenden Schicht, welche eine Emitterverbindung sowie zwei unterschiedliche Matrixmaterialien enthält.

Unter elektronischen Vorrichtungen im Sinne dieser Anmeldung werden sogenannte organische elektronische Vorrichtungen verstanden (organic electronic devices), welche organische Halbleitermaterialien als Funktionsmaterialien enthalten. Insbesondere werden darunter organische Elektrolumineszenzvorrichtungen (OLEDs) und andere elektronische Vorrichtungen verstanden, welche weiter unten aufgeführt sind.

Der Aufbau von OLEDs, in denen organische Halbleiter als funktionelle Materialien eingesetzt werden, ist beispielsweise in US 4539507, US 5151629, EP 0676461 und WO 98/27136 beschrieben. Allgemein werden unter der Bezeichnung OLED elektronische Vorrichtungen verstanden, welche organisches Material enthalten und unter Anlegen einer elektrischen Spannung Licht emittieren.

Bei elektronischen Vorrichtungen, insbesondere OLEDs, besteht großes Interesse an der Verbesserung der Leistungsdaten, insbesondere Lebensdauer und Effizienz. In diesen Punkten konnte, insbesondere bei blau emittierenden OLEDs, noch keine vollständig zufriedenstellende Lösung gefunden werden.

Um in diesen Punkten weitere Fortschritte zu erreichen, richtet sich besonderes Interesse auf die Zusammensetzung der emittierenden Schicht.

Im Stand der Technik ist bekannt, dass durch Verwendung von mehr als einer einzigen Verbindung in der emittierenden Schicht die Effizienz einer OLED gesteigert werden kann. Bei dieser technischen Lösung wird eine Emitterverbindung in Kombination mit einer zweiten Verbindung, die als Matrixverbindung dient, in der emittierenden Schicht eingesetzt. Die Matrixverbindung liegt dabei in überwiegendem Anteil in der Schicht vor.

Solche Ausführungsformen wurden für fluoreszierende emittierende Schichten unter anderem in US 4769292, US 5908581, US 5593788 und US 5141671 beschrieben.

Weiterhin wird in einigen Publikationen beschrieben, drei unterschiedliche Verbindungen in der emittierenden Schicht einer OLED einzusetzen. Typischerweise sind diese drei unterschiedlichen Verbindungen eine Emitterverbindung, eine erste Matrixverbindung und eine zweite Matrixverbindung.

Dabei wird unter einer Emitterverbindung eine Verbindung verstanden, die im Betrieb der elektronischen Vorrichtung Licht emittiert.

Liegt eine Mischung mehrerer Verbindungen in der emittierenden Schicht vor, so liegt die Emitterverbindung typischerweise als Mindermengen-Komponente vor, d.h. in geringerem Anteil als die weiteren in der Mischung der emittierenden Schicht vorhandenen Verbindungen. In diesem Fall wird die Emitterverbindung auch als Dotand bezeichnet.

Unter einer Matrixverbindung wird in diesem Fall eine Verbindung verstanden, die in größerem Anteil als die Emitterverbindung in der Mischung vorliegt. Bevorzugt emittiert die Matrixverbindung kein Licht. Auch wenn mehrere verschiedene Matrixverbindungen in der Mischung der emittierenden Schicht vorliegen, sind ihre einzelnen Anteile typischerweise größer als der Anteil der Emitterverbindungen, bzw. die Anteile der einzelnen Emitterverbindungen, sofern mehrere Emitterverbindungen in der Mischung der emittierenden Schicht vorliegen. Statt des Begriffs Matrixverbindung wird auch gleichbedeutend der Begriff Hostverbindung verwendet.

Im Stand der Technik wird in EP 1227527 eine OLED enthaltend die beiden Verbindungen Tris-(8-Hydroxychinolin)-Aluminium ($Alq_3$) und N,N'-Di-1-Naphthyl-N,N'-diphenyl-1,1'-biphenyl-4,4'-diamin (NPB) als Hostmaterialien sowie als Emitterverbindung Rubren offenbart.

Weiterhin wird in US 7504163 eine OLED enthaltend ein Anthracenderivat (2-Tert-butyl-9,10-bis(2-naphthalenyl)anthracen) als Hostmaterial, ein Perylenderivat als Emitterverbindung, sowie NPB als weitere Komponente offenbart. Dadurch wurde eine erhöhte Effizienz und/oder Lebensdauer gegenüber einer OLED, die kein NPB als weitere Komponente der emittierenden Schicht enthält, erreicht.

Es besteht jedoch weiterhin Interesse an OLEDs, welche hohe Effizienz und lange Lebensdauer aufweisen, inbesondere an blau fluoreszierenden OLEDs mit diesen Eigenschaften.

Überraschend wurde nun gefunden, dass durch Verwendung einer Emitterverbindung, die gewählt ist aus Verbindungen enthaltend mindestens eine kondensierte Arylgruppe bestehend aus 2 bis 4 miteinander kondensierten aromatischen Ringen, in den oben genannten emittierenden Schichten mit mindestens 2 Hostmaterialien, deutlich verbesserte Leistungsdaten erreicht werden können. Bevorzugt werden eine verbesserte Effizienz und eine verbesserte Lebensdauer der Vorrichtung erhalten.

Durch die relative Anordnung der HOMOs der Komponenten der emittierenden Schicht Matrixmaterial M1, Emitterverbindung E und Matrixmaterial M2 gemäß

HOMO (M1) > HOMO (E) > HOMO (M2)

wird der unerwartete Vorteil erreicht, dass sich die Lebensdauer der elektronischen Vorrichtung deutlich verbessert. Bevorzugt verbessern sich weiterhin die Effizienz der Vorrichtung und die Betriebsspannung.

Gegenstand der vorliegenden Erfindung ist somit eine elektronische Vorrichtung, enthaltend Anode, Kathode,

sowie mindestens eine emittierende Schicht,
wobei die emittierende Schicht mindestens eine Emitterverbindung E, mindestens ein Matrixmaterial M1 und mindestens ein Matrixmaterial M2 enthält,
wobei die Emitterverbindung E gewählt ist aus Verbindungen enthaltend mindestens eine kondensierte Aryl- oder Heteroarylgruppe bestehend aus 2 bis 4 miteinander kondensierten aromatischen Ringen,
wobei das Matrixmaterial M2 gewählt ist aus Verbindungen enthaltend mindestens eine Anthraceneinheit,
und wobei für die HOMOs der Verbindungen E, M1 und M2 gilt:

HOMO (M1) > HOMO (E) > HOMO (M2).

HOMO steht dabei wie allgemein üblich für das höchste besetzte Molekülorbital, insbesondere für die energetische Lage dieses Orbitals.

Die HOMO-Werte werden gemäß der vorliegenden Anmeldung durch quantenchemische Messungen bestimmt, wie in den Ausführungsbeispielen im Detail angegeben, und in eV (Elektronenvolt) angegeben. Dabei wird unter der Bezeichnung, dass ein HOMO-Wert größer ist als der andere (beispielsweise HOMO (M1) > HOMO (E)), verstanden, dass der entsprechende HOMO-Wert eine größere Zahl darstellt. Beispielsweise ist für HOMO (M1) = - 5.2 eV und HOMO (E) = -5.3 eV die Bedingung HOMO (M1) > HOMO (E) erfüllt.

Unter der Definition, dass die Emitterverbindung E gewählt ist aus Verbindungen enthaltend mindestens eine kondensierte Aryl- oder Heteroarylgruppe bestehend aus 2 bis 4 miteinander kondensierten aromatischen Ringen, ist zu verstehen, dass die kondensierte Aryl- oder Heteroarylgruppe genau 2, genau 3 oder genau 4 miteinander kondensierte aromatische oder heteroaromatische Ringe aufweisen muss. Miteinander kondensierte aromatische oder heteroaromatische Ringe sind solche aromatischen oder heteroaromatischen Ringe, welche mindestens eine aromatische Bindung miteinander teilen, d.h. mindestens zwei aneinander gebundene aromatische Ringatome. Sie können auch mehr als zwei aromatische Bindungen miteinander teilen. Die kondensierte Aryl- oder Heteroarylgruppe hat bevorzugt 10 bis 18 aromatische Ringatome, besonders bevorzugt genau 10, genau 14, genau 16 oder genau 18 aromatische Ringatome. Bevorzugt ist sie eine kondensierte Arylgruppe und keine kondensierte Heteroarylgruppe. Die kondensierte Aryl- oder Heteroarylgruppe kann beliebige weitere Substituenten tragen. Dabei können die Substituenten der Gruppe auch Ringe bilden. Diese Ringe können auch an die kondensierte Aryl- oder Heteroarylgruppe ankondensiert sein. Definitionsgemäß dürfen diese ankondensierten Ringe jedoch keine aromatischen oder heteroaromatischen Ringe sein, da die Zahl der miteinander kondensierten aromatischen oder heteroaromatischen Ringe der kondensierten Arylgruppe, wie oben erläutert, auf genau 2, genau 3 oder genau 4 definiert ist.

Es folgen Definitionen für chemische Gruppen gemäß der vorliegenden Anmeldung:

Eine Arylgruppe im Sinne dieser Erfindung enthält 6 bis 60 aromatische Ringatome; eine Heteroarylgruppe im Sinne dieser Erfindung enthält 5 bis 60 aromatische Ringatome, von denen mindestens eines ein Heteroatom darstellt. Die Heteroatome sind bevorzugt ausgewählt aus N, O und S. Dies stellt die grundlegende Definition dar. Werden in der Beschreibung der vorliegenden Erfindung andere Bevorzugungen angegeben, beispielsweise bezüglich der Zahl der aromatischen Ringatome oder der enthaltenen Heteroatome, so gelten diese.

Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin oder Thiophen, oder ein kondensierter (annellierter) aromatischer bzw. heteroaromatischer Polycyclus, beispielsweise Naphthalin, Phenanthren, Chinolin oder Carbazol verstanden. Ein kondensierter (annellierter) aromatischer bzw. heteroaromatischer Polycyclus besteht im Sinne der vorliegenden Anmeldung aus zwei oder mehr miteinander kondensierten einfachen aromatischen bzw. heteroaromatischen Cyclen. Er wird auch, wie oben definiert, als kondensierte Aryl- oder Heteroarylgruppe bezeichnet.

Unter einer Aryl- oder Heteroarylgruppe, die jeweils mit den oben genannten Resten substituiert sein kann und die über beliebige Positionen am Aromaten bzw. Heteroaromaten verknüpft sein kann, werden insbesondere Gruppen verstanden, welche abgeleitet sind von Benzol, Naphthalin, Anthracen, Phenanthren, Pyren, Dihydropyren, Chrysen, Perylen, Fluoranthen, Benzanthracen, Benzphenanthren, Tetracen, Pentacen, Benzpyren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Unter einer Aryloxygruppe gemäß der Definition der vorliegenden Erfindung wird eine Arylgruppe, wie oben

definiert, verstanden, welche über ein Sauerstoffatom gebunden ist. Eine analoge Definition gilt für Heteroaryloxygruppen.

Ein aromatisches Ringsystem im Sinne dieser Erfindung enthält 6 bis 60 C-Atome im Ringsystem. Ein heteroaromatisches Ringsystem im Sinne dieser Erfindung enthält 5 bis 60 aromatische Ringatome, von denen mindestens eines ein Heteroatom darstellt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein $sp^3$-hybridisiertes C-, Si-, N- oder O-Atom, ein $sp^2$-hybridisiertes C- oder N-Atom oder ein sp-hybridisiertes C-Atom, verbunden sein können. So sollen beispielsweise auch Systeme wie 9,9'-Spirobifluoren, 9,9'-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkyl-, Alkenyl- oder Alkinylgruppe oder durch eine Silylgruppe verbunden sind. Weiterhin werden auch Systeme, in denen zwei oder mehr Aryl- oder Heteroarylgruppen über Einfachbindungen miteinander verknüpft sind, als aromatische oder heteroaromatische Ringsysteme im Sinne dieser Erfindung verstanden, wie beispielsweise Systeme wie Biphenyl, Terphenyl oder Diphenyltriazin.

Unter einem aromatischen oder heteroaromatischen Ringsystem mit 5 - 60 aromatischen Ringatomen, welches noch jeweils mit Resten wie oben definiert substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Benzphenanthren, Pyren, Chrysen, Perylen, Fluoranthen, Naphthacen, Pentacen, Benzpyren, Biphenyl, Biphenylen, Terphenyl, Terphenylen, Quaterphenyl, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Kombinationen dieser Gruppen.

Im Rahmen der vorliegenden Erfindung werden unter einer geradkettigen Alkylgruppe mit 1 bis 40 C-Atomen bzw. einer verzweigten oder cyclischen Alkylgruppe mit 3 bis 40 C-Atomen bzw. einer Alkenyl- oder Alkinylgruppe mit 2 bis 40 C-Atomen, in der auch einzelne H-Atome oder $CH_2$-Gruppen durch die oben bei der Definition der Reste genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, neoPentyl, n-Hexyl, Cyclohexyl, neo-Hexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer Alkoxy- oder Thioalkylgruppe mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy, 2,2,2-Trifluorethoxy, Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden.

Unter der Formulierung, dass zwei oder mehr Reste miteinander einen Ring bilden können, soll im Rahmen der vorliegenden Anmeldung unter anderem verstanden werden, dass die beiden Reste miteinander durch eine chemische Bindung verknüpft sind. Dies wird durch das folgende Schema verdeutlicht:

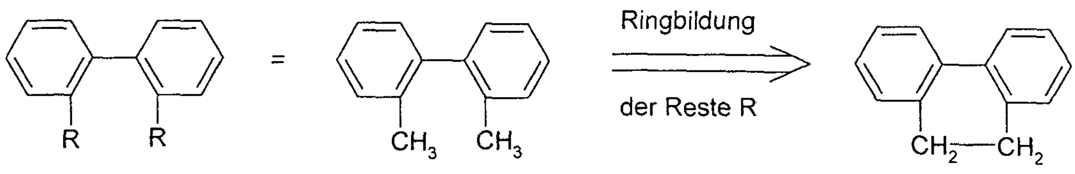


Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

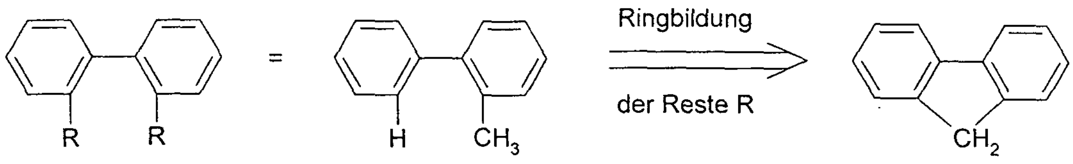


Gemäß einer bevorzugten Ausführungsform der Erfindung ist die Emitterverbindung E ein kleines organisches Molekül. Bevorzugt ist sie kein Polymer, Dendrimer oder Oligomer. Bevorzugt weist sie ein Molekulargewicht von 200 bis 2000 g/mol, besonders bevorzugt 250 bis 1500 g/mol und ganz besonders bevorzugt von 300 bis 1000 g/mol auf.

Bevorzugt enthält die Emitterverbindung E keine kondensierte Aryl- oder Heteroarylgruppe mit mehr als vier miteinander kondensierten aromatischen Ringen.

Weiterhin ist es bevorzugt, dass die Emitterverbindung E keine Arylaminogruppe aufweist. Besonders bevorzugt weist sie keine Aminogruppe auf. Unter einer Arylaminogruppe wird im Sinne dieser Anmeldung eine Gruppe verstanden, in der mindestens eine Arylgruppe oder Heteroarylgruppe an ein dreibindiges Stickstoffatom gebunden ist. Wie die Gruppe weiter aufgebaut ist, oder welche weiteren Gruppen sie umfasst, ist für die Definition unerheblich.

Weiterhin ist es bevorzugt, dass die Emitterverbindung E mindestens eine Gruppe gewählt aus Pyrenylgruppen, Anthracenylgruppen, Fluorenylgruppen und Indenofluorenylgruppen aufweist. Es ist dabei bevorzugt, dass die Fluorenylgruppe einen, zwei oder drei ankondensierte Benzolringe aufweist, so dass eine Benzofluorenylgruppe entsteht. Die Benzolringe sind dabei bevorzugt an Benzolringe der Fluorengruppe ankondensiert. Weiterhin ist es bevorzugt, dass die Indenofluorenylgruppe einen, zwei oder drei ankondensierte Benzolringe aufweist, so dass eine Benzoindenofluorengruppe entsteht. Die Benzolringe sind dabei bevorzugt an Benzolringe der Indenofluorengruppe ankondensiert.

Besonders bevorzugte Emitterverbindungen E sind gewählt aus den in WO 2006/108497 offenbarten Indenofluoren-Aminen, aus den in WO 2007/065678 offenbarten Anthracen-Derivaten, aus den in WO 2007/140847offenbarten Dibenzoindenofluorenen, aus den in WO 2008/006449 offenbarten Monobenzoindenofluorenen, aus den in WO 2009/127307 offenbarten Diindenoanthracenen, aus den in WO 2010/012328 offenbarten Benzoindenofluorenen enthaltend große kondensierte Arylgruppen, aus den in WO 2010/049050 offenbarten mehrfach verbrückten kondensierten Aromaten, und aus den in der noch nicht offen gelegten Anmeldung EP 12006239.3 offenbarten Benzoindenofluoren-Aminen. Besonders bevorzugt sind davon die in der genannten WO 2010/012328 offenbarten Benzoindenofluorene mit großen kondensierten Arylgruppen.

Bevorzugt ist die Emitterverbindung E eine Verbindung der folgenden Formel (I)

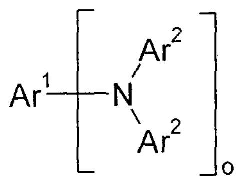

Formel (I), wobei

wobei gilt:

$Ar^1$ ist ein aromatisches oder heteroaromatisches Ringsystem mit 10 bis 40 aromatischen Ringatomen, enthaltend mindestens eine kondensierte Aryl- oder Heteroarylgruppe bestehend aus 2 bis 4 miteinander kondensierten aromatischen Ringen, wobei das aromatische oder heteroaromatische Ringsystem mit einem oder mehreren

Resten $R^1$ substituiert sein kann;

$Ar^2$ ist ein aromatisches oder heteroaromatisches Ringsystem mit 6 bis 40 aromatischen Ringatomen, das mit einem oder mehreren Resten $R^1$ substituiert sein kann;

$R^1$ ist bei jedem Auftreten gleich oder verschieden H, D, F, $C(=O)R^2$, CN, $Si(R^2)_3$, $N(R^2)_2$, $P(=O)(R^2)_2$, $S(=O)R^2$, $S(=O)_2R^2$, eine geradkettige Alkyl- oder Alkoxygruppe mit 1 bis 20 C-Atomen oder eine verzweigte oder cyclische Alkyl- oder Alkoxygruppe mit 3 bis 20 C-Atomen oder eine Alkenyl- oder Alkinylgruppe mit 2 bis 20 C-Atomen, wobei die oben genannten Gruppen jeweils mit einem oder mehreren Resten $R^2$ substituiert sein können und wobei eine oder mehrere $CH_2$-Gruppen in den oben genannten Gruppen durch $-R^2C=CR^2-$, $-C\equiv C-$, $Si(R^2)_2$, C=O, C=S, $C=NR^2$, -C(=O)O-, $-C(=O)NR^2-$, $NR^2$, $P(=O)(R^2)$, -O-, -S-, SO oder $SO_2$ ersetzt sein können und wobei ein oder mehrere H-Atome in den oben genannten Gruppen durch D, F oder CN ersetzt sein können, oder ein aromatisches oder heteroaromatisches Ringsystem mit 5 bis 30 aromatischen Ringatomen, das jeweils durch einen oder mehrere Reste $R^2$ substituiert sein kann, oder eine Aryloxy- oder Heteroaryloxygruppe mit 5 bis 30 aromatischen Ringatomen, die durch einen oder mehrere Reste $R^2$ substituiert sein kann, wobei zwei oder mehr Reste $R^1$ miteinander verknüpft sein können und einen Ring bilden können;

$R^2$ ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten $R^2$ miteinander verknüpft sein und einen Ring bilden; und

o ist 0, 1, 2, 3 oder 4.

Bevorzugt ist in Formel (I) o gleich 0, 1 oder 2, besonders bevorzugt gleich 0 oder 1, ganz besonders bevorzugt gleich 0.

Weiterhin bevorzugt ist in Formel (I) $Ar^1$ gewählt aus folgenden Gruppen:

| | |
|---|---|
| 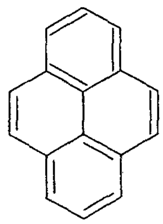 | 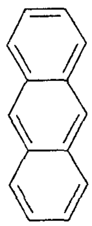 |
| $Ar^1$ -1 | $Ar^1$-2 |
| | |
| 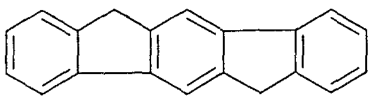 | 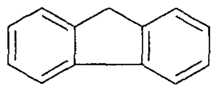 |
| $Ar^1$-3 | $Ar^1$-4 |
| | |
| 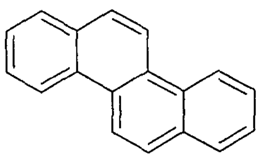 | 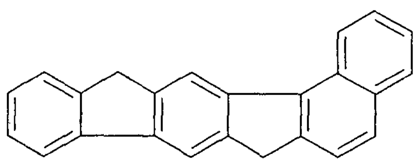 |
| $Ar^1$-5 | $Ar^1$-6 |
| | |

(fortgesetzt)

| | |
|---|---|
| 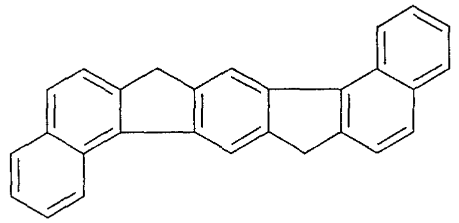 | |
| $Ar^1$-7 | |

wobei die Gruppen an allen freien Positionen mit einem oder mehreren Resten $R^1$ substituiert sein können, und wobei die Gruppen der Formel $Ar^1$-3 und $Ar^1$-4 mindestens einen zusätzlichen ankondensierten aromatischen Ring aufweisen müssen, der an einen der Sechsringe ankondensiert ist.

Es ist bevorzugt, dass die Gruppen der Formel $Ar^1$-3 und $Ar^1$-4 zwei oder drei zusätzliche ankondensierte aromatische Ringe aufweisen, die an einen einzigen oder an mehrere unterschiedliche Sechsringe ankondensiert sein können. Bevorzugt sind die ankondensierten aromatischen Ringe Sechsringe.

In Kombination mit der Wahl von $Ar^1$ aus einer der oben genannten Gruppen $Ar^1$-1 bis $Ar^1$-7 ist o in Formel (I) bevorzugt gleich 0.

Besonders bevorzugt sind Verbindungen gemäß Formel (I), ausgewählt aus den Formeln (I-1) bis (I-31), wobei die aromatischen Systeme jeweils durch einen oder mehrere Reste $R^1$ substituiert sein können:

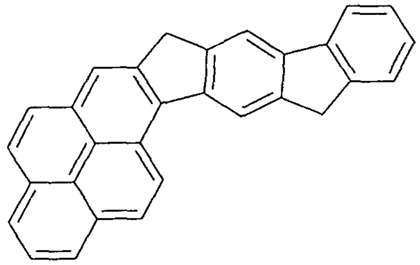

Formel (I-1)

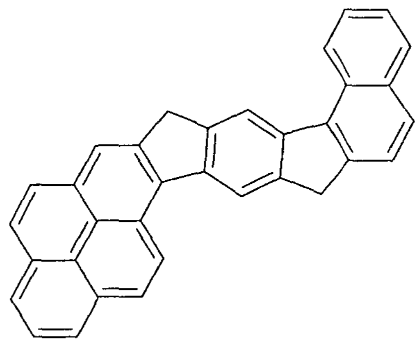

Formel (I-2)

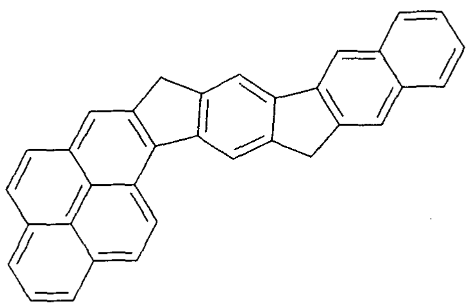

Formel (I-3)

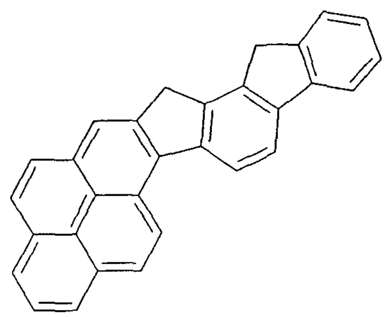

Formel (I-4)

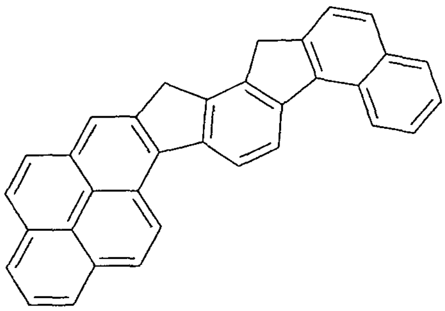

Formel (I-5)

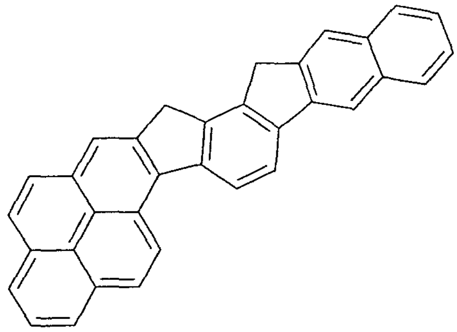

Formel (I-6)

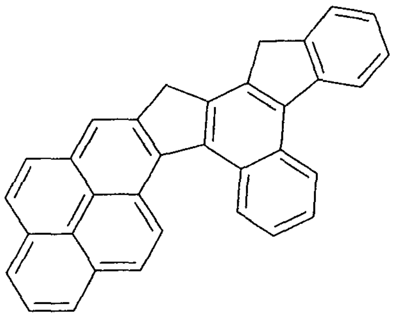

Formel (I-7)

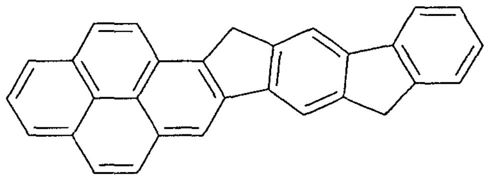

Formel (I-8)

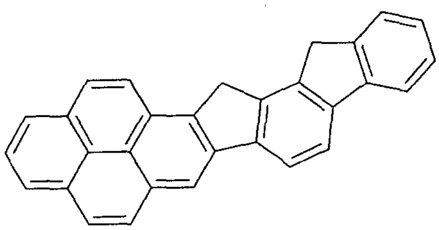

Formel (I-9)

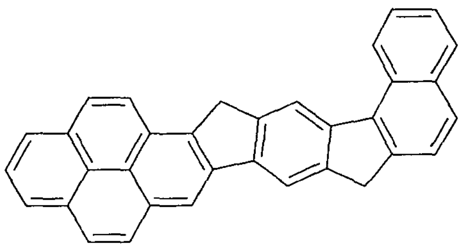

Formel (I-10)

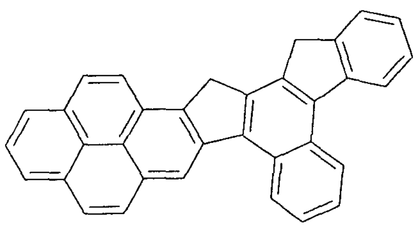

Formel (I-11)

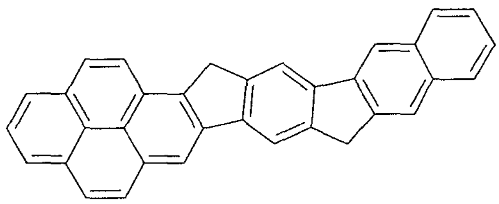

Formel (I-12)

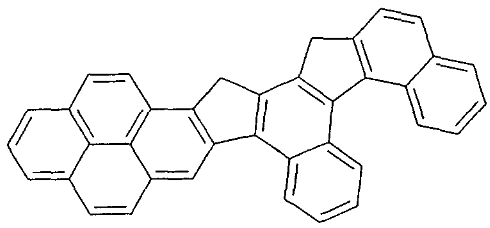

Formel (I-13)

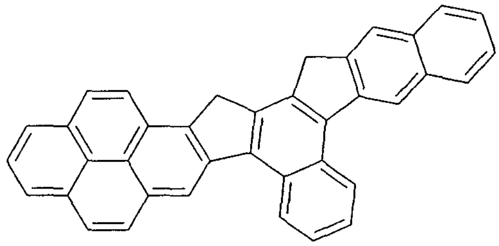

Formel (I-14)

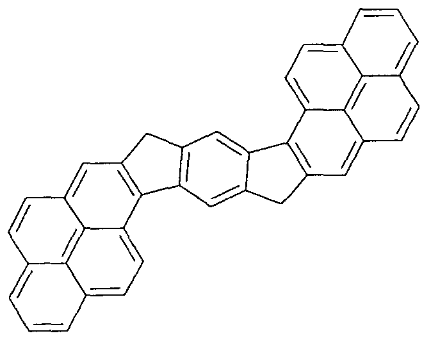

Formel (I-15)

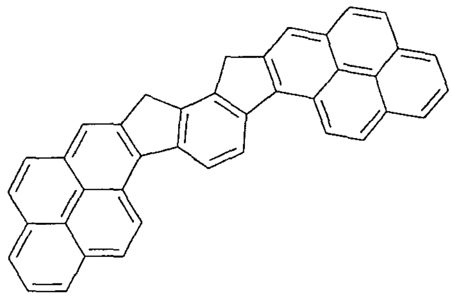

Formel (I-16)

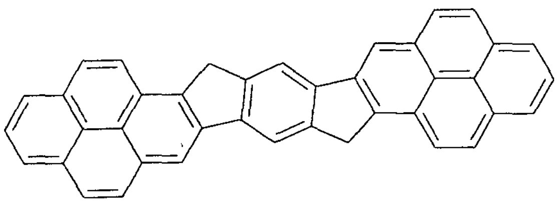

Formel (I-17)

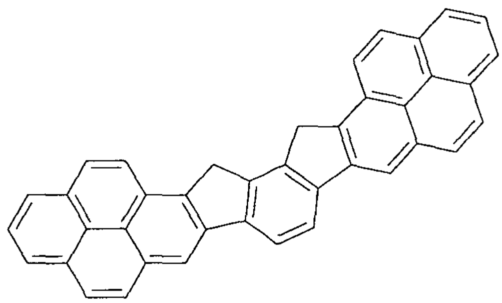

Formel (I-18)

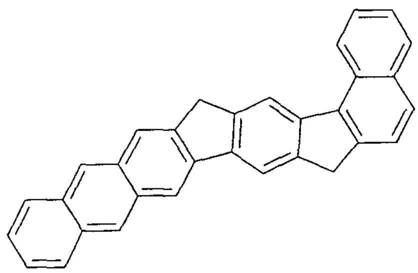

Formel (I-19)

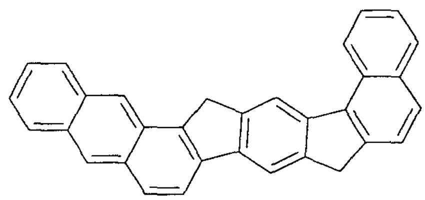

Formel (I-20)

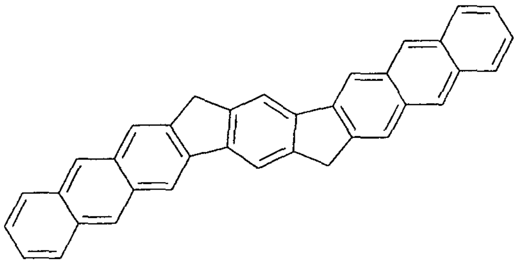

Formel (I-21)

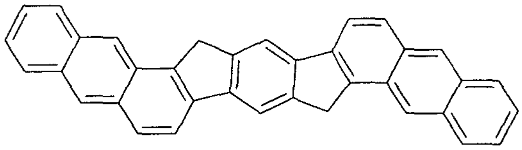

Formel (I-22)

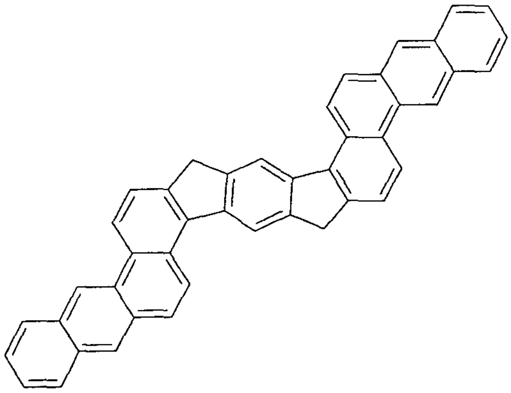

Formel (I-23)

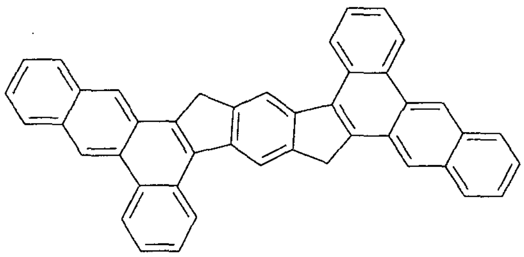

Formel (I-24)

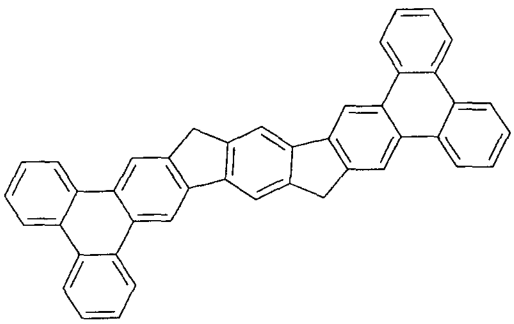

Formel (I-25)

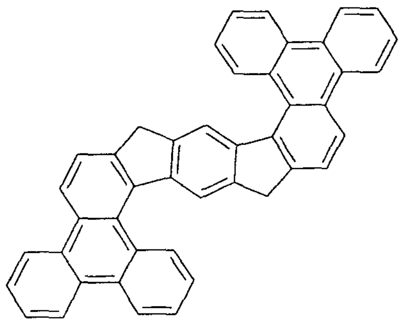

Formel (I-26)

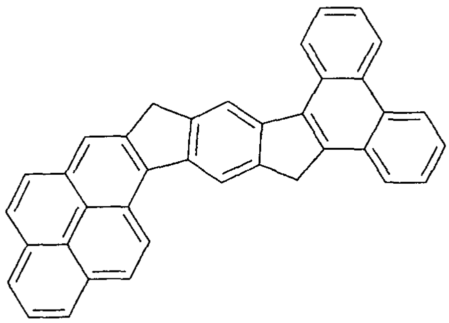

Formel (I-27)

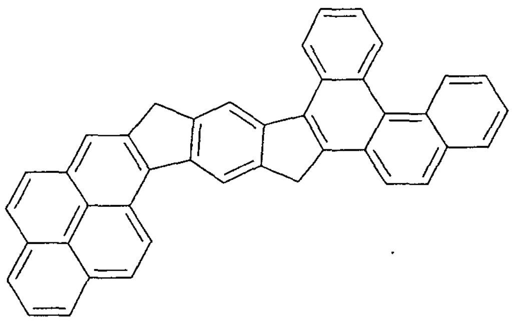

Formel (I-28)

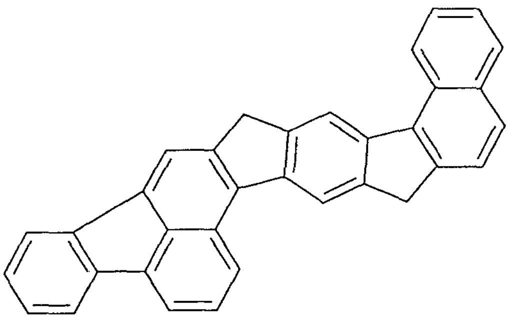

Formel (I-29)

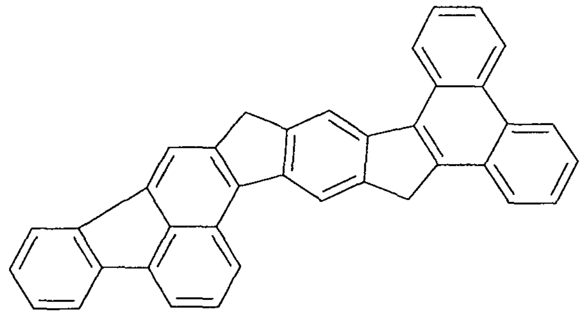

Formel (I-30)

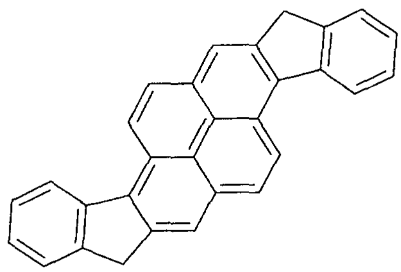

Formel (I-31)

Gemäß einer bevorzugten Ausführungsform der Erfindung ist die Emitterverbindung E eine fluoreszierende Verbindung.

Unter Fluoreszenz wird im Rahmen der vorliegenden Anmeldung Emission aus einem Übergang aus einem angeregten Singulett-Zustand verstanden.

Bevorzugt liegt das HOMO der Emitterverbindung E zwischen -7.9 eV und -3.9 eV, bevorzugt zwischen -6.4 eV und -4.1 eV und ganz besonders bevorzugt zwischen -6.1 eV und -5.1 eV.

Gemäß einer bevorzugten Ausführungsform der Erfindung ist das Matrixmaterial M1 ein kleines organisches Molekül. Bevorzugt ist es kein Polymer, Dendrimer oder Oligomer. Bevorzugt weist es ein Molekulargewicht von 200 bis 2000 g/mol, besonders bevorzugt 250 bis 1500 g/mol und ganz besonders bevorzugt von 300 bis 1000 g/mol auf.

Bevorzugt ist das Matrixmaterial M1 gewählt aus einer Triarylamino-Verbindung. Unter einer Triarylamino-Verbindung gemäß der vorliegenden Anmeldung wird eine Verbindung verstanden, in der drei Aryl- oder Heteroarylgruppen an ein gemeinsames Stickstoffatom gebunden sind. Die Aryl- oder Heteroarylgruppen, die an das gemeinsame Stickstoffatom binden, können über divalente Gruppen oder Einfachbindungen miteinander verbunden sein. Bevorzugt sind sie nicht miteinander verbunden. Die Triarylamino-Verbindung kann neben der genannten Struktureinheit beliebige weitere Gruppen und Substituenten aufweisen.

Besonders bevorzugt ist das Matrixmaterial M1 gewählt aus einer Mono-Triarylamino-Verbindung. Unter einer Mono-Triarylamino-Verbindung wird eine Verbindung verstanden, die genau eine Triarylaminogruppe, wie oben definiert, aufweist. Sie weist keine weiteren Triarylaminogruppen auf. Bevorzugt weist sie keine weiteren Aminogruppen auf.

Besonders bevorzugt ist das Matrixmaterial M1 gewählt aus Verbindungen der Formel (II)

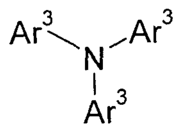

Formel (II),

wobei gilt:

$Ar^3$ ist bei jedem Auftreten gleich oder verschieden ein aromatisches oder heteroaromatisches Ringsystem mit 5 bis 50 aromatischen Ringatomen, das mit einem oder mehreren Resten $R^3$ substituiert sein kann; und

$R^3$ ist bei jedem Auftreten gleich oder verschieden H, D, F, $C(=O)R^4$, CN, $Si(R^4)_3$, $P(=O)(R^4)_2$, $S(=O)R^4$, $S(=O)_2R^4$,

eine geradkettige Alkyl- oder Alkoxygruppe mit 1 bis 20 C-Atomen oder eine verzweigte oder cyclische Alkyl- oder Alkoxygruppe mit 3 bis 20 C-Atomen oder eine Alkenyl- oder Alkinylgruppe mit 2 bis 20 C-Atomen, wobei die oben genannten Gruppen jeweils mit einem oder mehreren Resten $R^4$ substituiert sein können und wobei eine oder mehrere $CH_2$-Gruppen in den oben genannten Gruppen durch $-R^4C=CR^4-$, -C≡C-, $Si(R^4)_2$, C=O, C=S, $C=NR^4$, -C(=O)O-, $-C(=O)NR^4-$, $P(=O)(R^4)$, -O-, -S-, SO oder $SO_2$ ersetzt sein können und wobei ein oder mehrere H-Atome in den oben genannten Gruppen durch D, F oder CN ersetzt sein können, oder ein aromatisches oder heteroaromatisches Ringsystem mit 5 bis 30 aromatischen Ringatomen, das jeweils durch einen oder mehrere Reste $R^4$ substituiert sein kann, oder eine Aryloxy- oder Heteroaryloxygruppe mit 5 bis 30 aromatischen Ringatomen, die durch einen oder mehrere Reste $R^4$ substituiert sein kann, wobei zwei oder mehr Reste $R^3$ miteinander verknüpft sein können und einen Ring bilden können;

$R^4$ ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten $R^4$ miteinander verknüpft sein und einen Ring bilden.

$Ar^3$ ist bevorzugt ein aromatisches Ringsystem mit 6 bis 30 aromatischen Ringatomen, das mit einem oder mehreren Resten $R^3$ substituiert sein kann. Besonders bevorzugt enthält $Ar^3$ eine mit $R^3$ substituierte oder unsubstituierte Gruppe gewählt aus Fluoren, Indenofluoren, Spirobifluoren, Phenyl, Biphenyl, Terphenyl oder Naphthyl.

Weiterhin bevorzugt umfasst $Ar^3$ keine kondensierte Arylgruppe mit mehr als 14 aromatischen Ringatomen, besonders bevorzugt umfasst $Ar^3$ keine kondensierte Arylgruppe mit mehr als 10 aromatischen Ringatomen.

Weiterhin bevorzugt umfasst $Ar^3$ keine kondensierte Heteroarylgruppe mit mehr als 14 aromatischen Ringatomen, besonders bevorzugt umfasst $Ar^3$ keine kondensierte Heteroarylgruppe mit mehr als 10 aromatischen Ringatomen.

Bevorzugt ist das Matrixmaterial M1 gewählt aus Verbindungen der Formeln (II-1) bis (II-6)

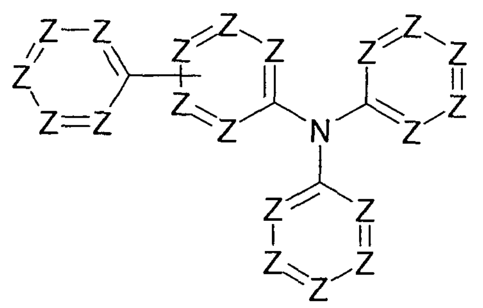

Formel (II-1)

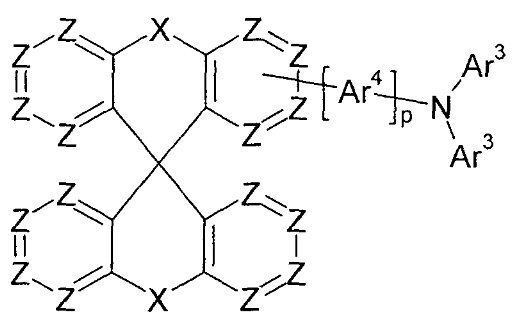

Formel (II-2)

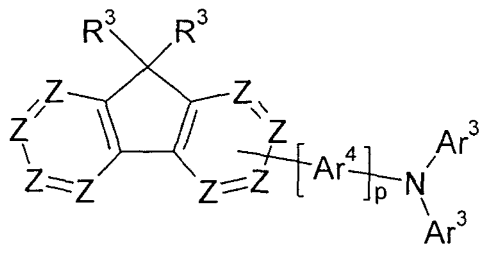

Formel (II-3)

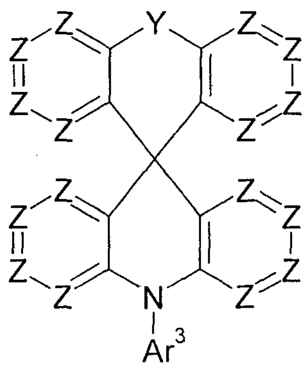

Formel (II-4)

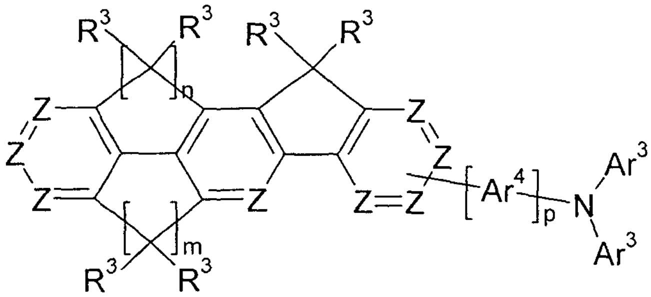

Formel (II-5)

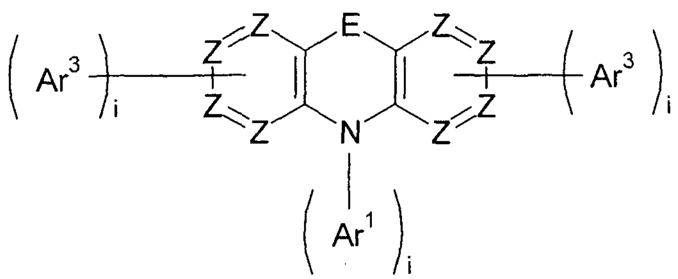

Formel (II-6)

enthält, wobei gilt:

Z ist bei jedem Auftreten gleich oder verschieden N oder $CR^3$, wobei Z gleich C ist, wenn ein Substituent gebunden ist;

X ist bei jedem Auftreten gleich oder verschieden eine Einfachbindung, O, S, Se, $BR^3$, $C(R^3)_2$, $Si(R^3)_2$, $NR^3$, $PR^3$, $C(R^3)_2$-$C(R^3)_2$, oder $CR^3$=$CR^3$;

Y ist eine Einfachbindung, O, S, Se, $BR^3$, $C(R^3)_2$, $Si(R^3)_2$, $NR^3$, $PR^3$, $C(R^3)_2$-$C(R^3)_2$, oder $CR^3$=$CR^3$;

E ist O, S, Se, $BR^3$, $C(R^3)_2$, $Si(R^3)_2$, $NR^3$, $PR^3$, $C(R^3)_2$-$C(R^3)_2$, oder $CR^3$=$CR^3$;

$Ar^3$ ist definiert wie oben;

$Ar^4$ ist ein aromatisches oder heteroaromatisches Ringsystem mit 6 bis 18 aromatischen Ringatomen, das mit einem oder mehreren Resten $R^3$ substituiert sein kann;

$R^3$ ist definiert wie oben;

i ist bei jedem Auftreten gleich oder verschieden 0 oder 1, wobei die Summe aller i mindestens gleich 1 ist;

p ist gleich 0 oder 1;

m, n sind gleich oder verschieden 0 oder 1, wobei die Summe aus m und n gleich 1 oder 2 ist.

Für die oben genannten Formeln (II-1) bis (II-6) gilt bevorzugt, dass nicht mehr als drei Gruppen Z in einem Ring gleich N sind. Es ist allgemein bevorzugt, dass Z gleich $CH^3$ ist.

Die Gruppe X ist bei jedem Auftreten bevorzugt gleich oder verschieden gewählt aus einer Einfachbindung, $C(R^3)_2$, O und S, besonders bevorzugt ist sie eine Einfachbindung.

Die Gruppe Y ist bevorzugt gewählt aus O und $C(R^3)_2$, besonders bevorzugt ist sie O.

Die Gruppe E ist bevorzugt gewählt aus $C(R^3)_2$, O und S, besonders bevorzugt ist sie $C(R^3)_2$.

Die Gruppe $Ar^3$ ist bevorzugt bei jedem Auftreten gleich oder verschieden gewählt aus aromatischen oder heteroaromatischen Ringsystemen mit 6 bis 30 aromatischen Ringatomen, die mit einem oder mehreren Resten $R^3$ substituiert sein können. Besonders bevorzugt ist $Ar^3$ gewählt aus Aryl- oder Heteroarylgruppen mit 6 bis 18 aromatischen Ringatomen, die mit einem oder mehreren Resten $R^3$ substituiert sein können.

Beispiele für Verbindungen, die als Matrixmaterial M1 in der erfindungsgemäßen elektronischen Vorrichtung eingesetzt werden, sind im Folgenden aufgeführt:

| | | | | | |
|---|---|---|---|---|---|
| 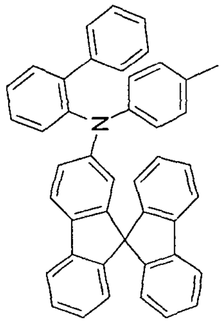 | M1-3 | 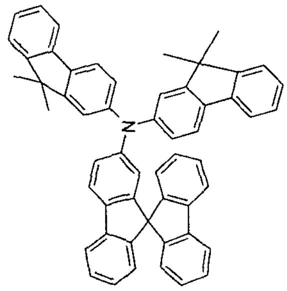 | M1-6 | 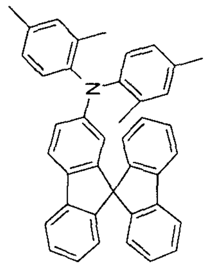 | M1-9 |
| 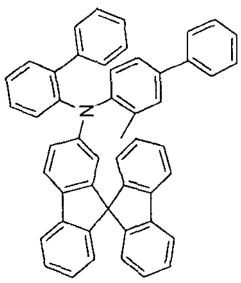 | M1-2 | 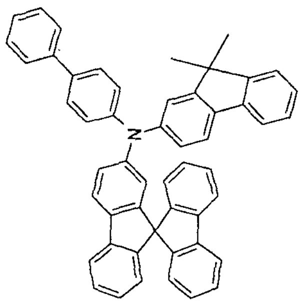 | M1-5 | 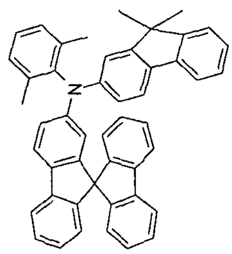 | M1-8 |
| 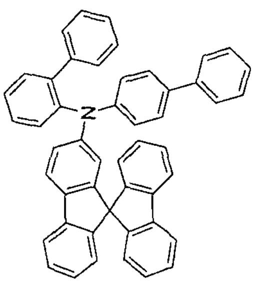 | M1-1 | 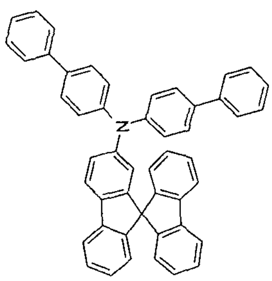 | M1-4 | 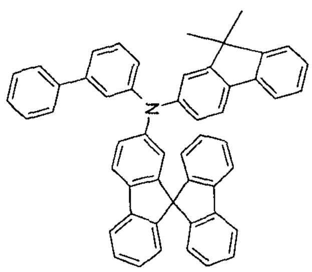 | M1-7 |

(fortgesetzt)

| | | |
|---|---|---|
| 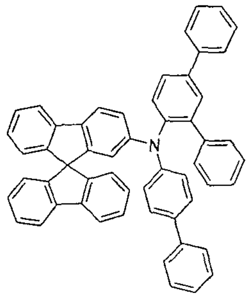 | 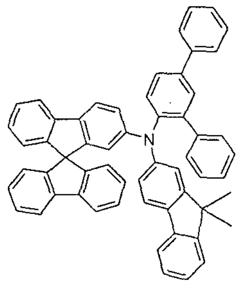 | 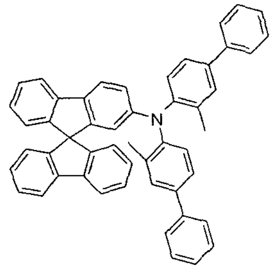 |
| M1-10 | M1-11 | M1-12 |
| 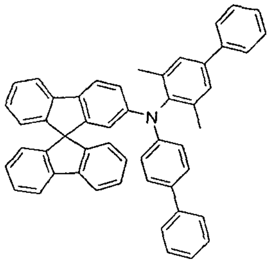 | 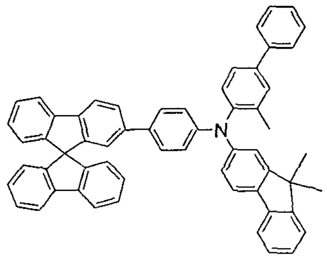 | 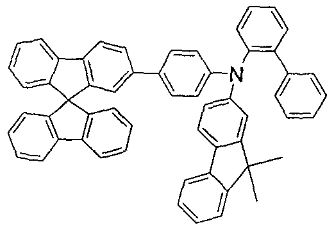 |
| M1-13 | M1-14 | M1-15 |
| 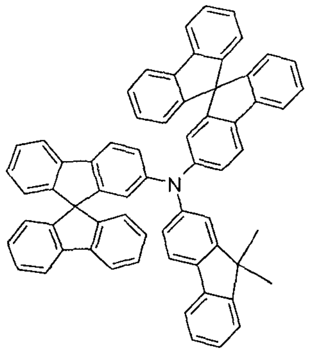 | 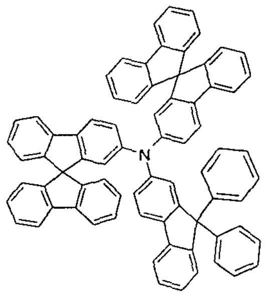 | 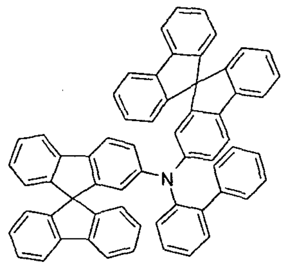 |
| M1-16 | M1-17 | M1-18 |

(fortgesetzt)

| | | |
|---|---|---|
| 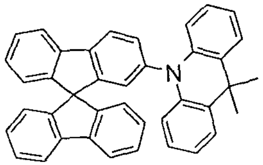 | 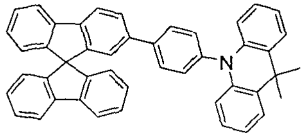 | 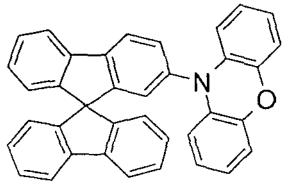 |
| M1-19 | M1-20 | M1-21 |
| 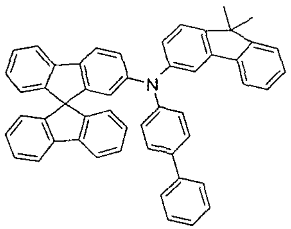 | 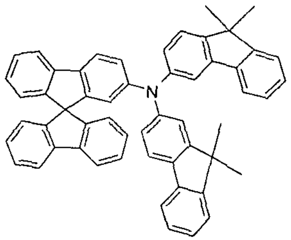 | 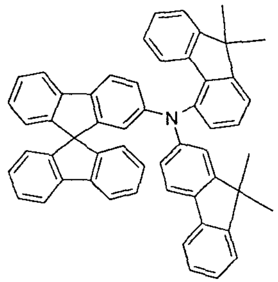 |
| M1-22 | M1-23 | M1-24 |
| 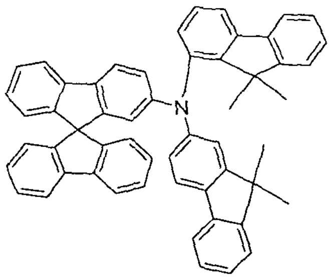 | 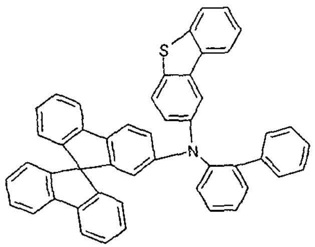 | 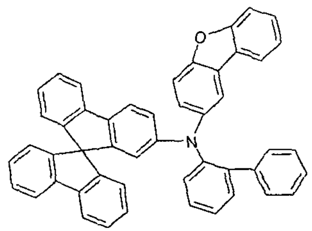 |
| M1-25 | M1-26 | M1-27 |

(fortgesetzt)

| | | |
|---|---|---|
| 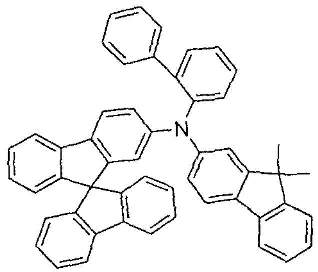 | 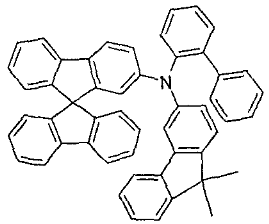 | 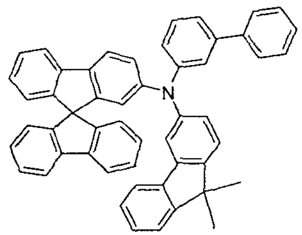 |
| M1-28 | M1-29 | M1-30 |
| 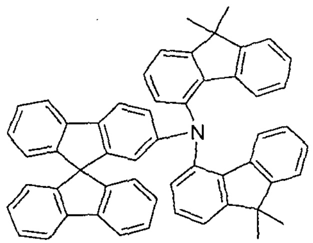 | 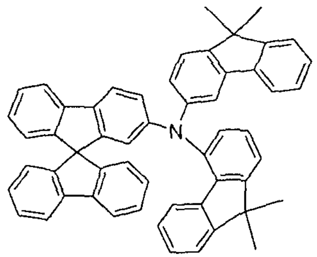 | 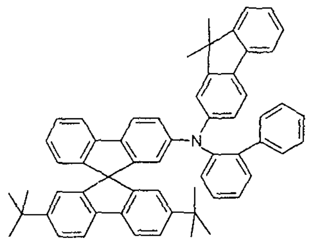 |
| M1-31 | M1-32 | M1-33 |
| 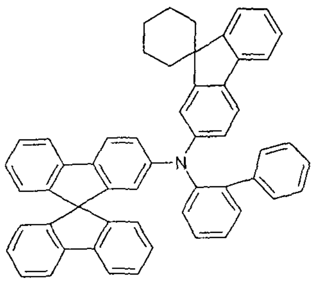 | 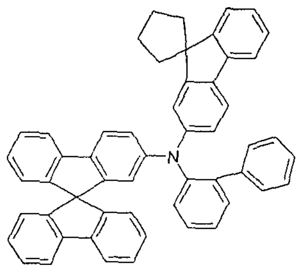 | 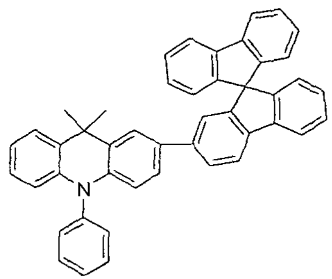 |
| M1-34 | M1-35 | M1-36 |

(fortgesetzt)

| | | |
|---|---|---|
| 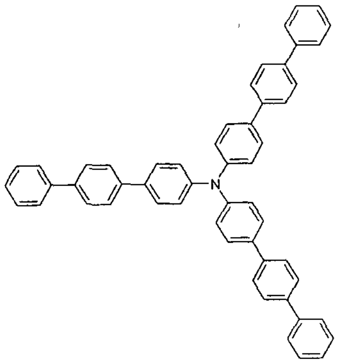 | 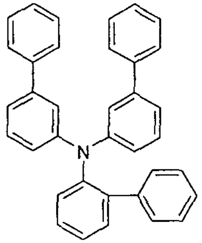 | 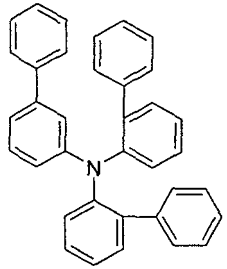 |
| M1-37 | M1-38 | M1-39 |
| 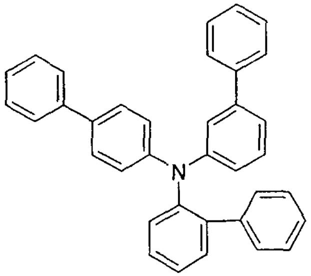 | 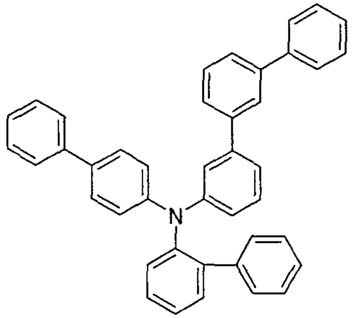 | 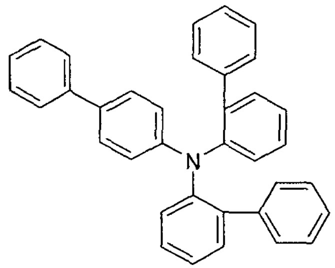 |
| M1-40 | M1-41 | M1-42 |

(fortgesetzt)

| | | | | | |
|---|---|---|---|---|---|
| 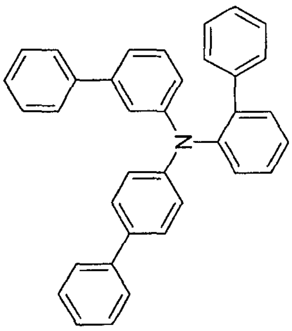 | M1-43 | 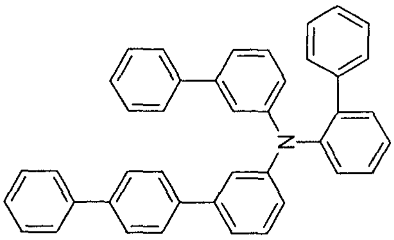 | M1-44 | 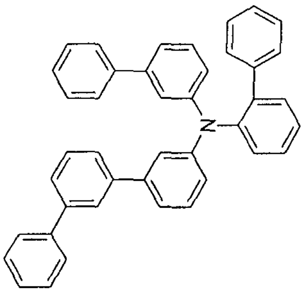 | M1-45 |
| 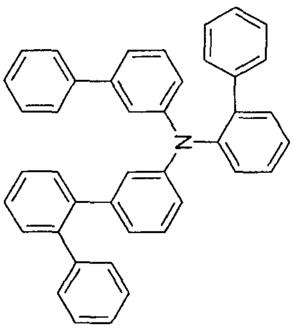 | M1-46 | 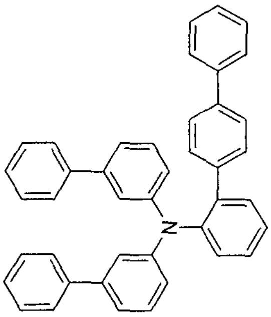 | M1-47 | 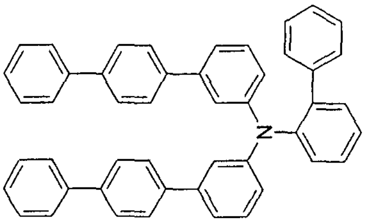 | M1-48 |

(fortgesetzt)

| | | |
|---|---|---|
| 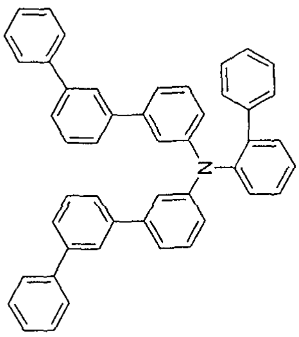 | 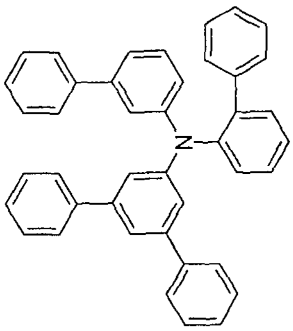 | 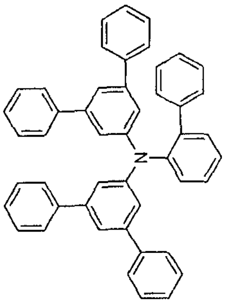 |
| M1-49 | M1-50 | M1-51 |
| 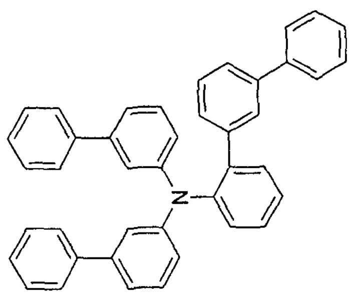 | 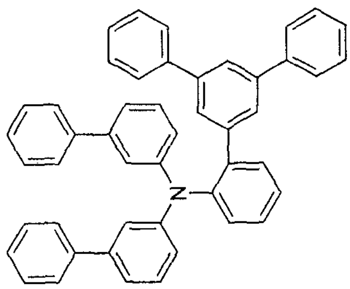 | 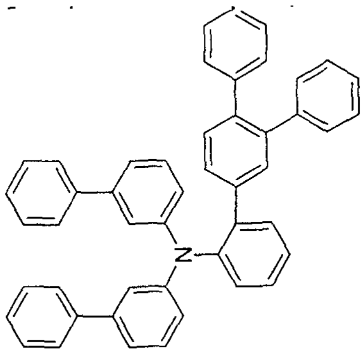 |
| M1-52 | M1-53 | M1-54 |
| 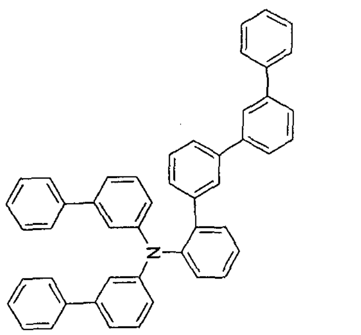 | 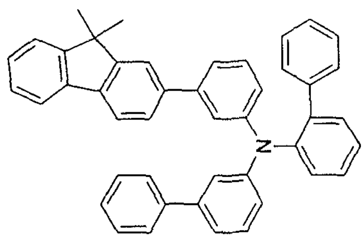 | 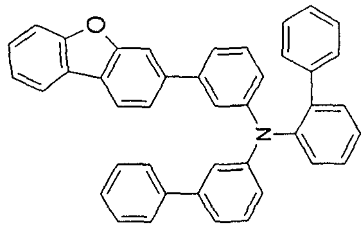 |

(fortgesetzt)

| | | |
|---|---|---|
| M1-55 | M1-56 | M1-57 |
| 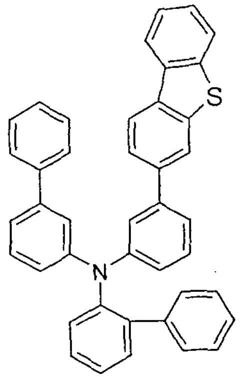 | 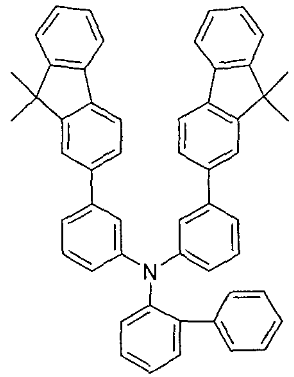 | 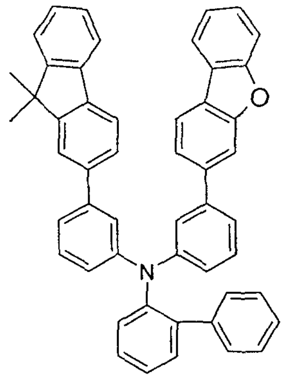 |
| M1-58 | M1-59 | M1-60 |
| 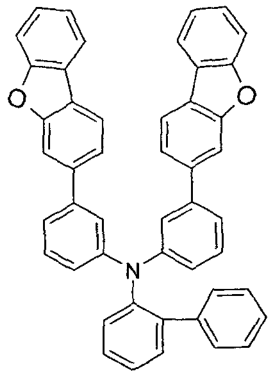 | 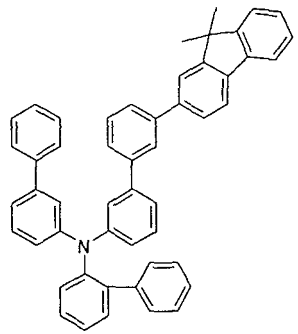 | 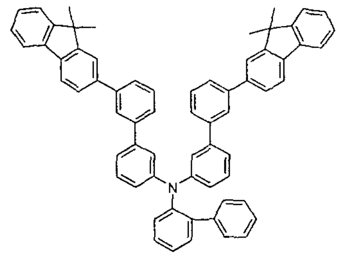 |
| M1-61 | M1-62 | M1-63 |

(fortgesetzt)

| | | |
|---|---|---|
| 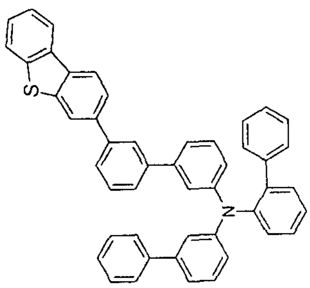 | 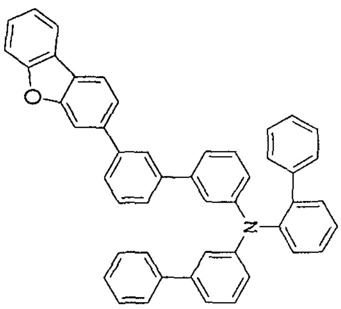 | 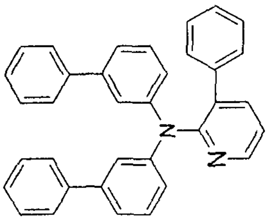 |
| M1-64 | M1-65 | M1-66 |
| 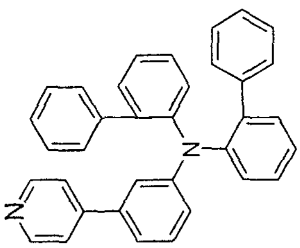 | 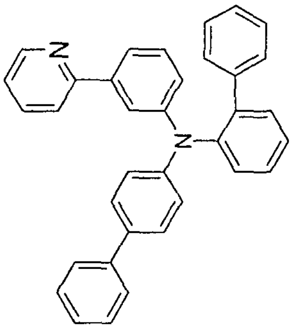 | 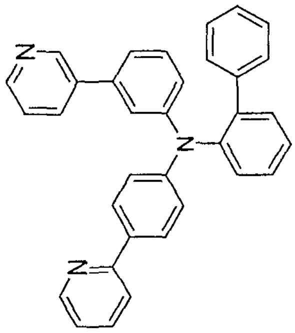 |
| M1-67 | M1-68 | M1-69 |
| 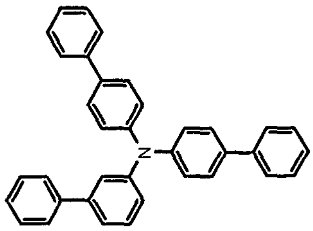 | 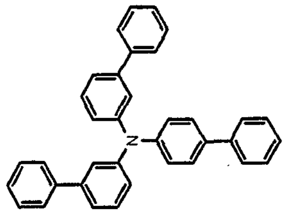 | 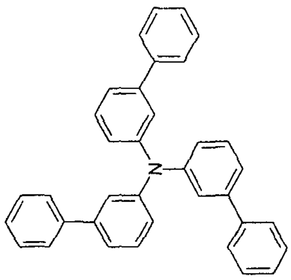 |
| M1-70 | M1-71 | M1-72 |

(fortgesetzt)

| | | |
|---|---|---|
| 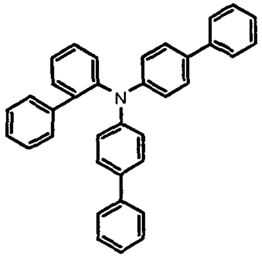 | 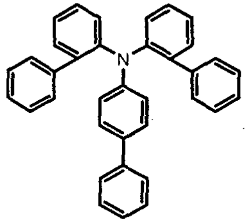 | 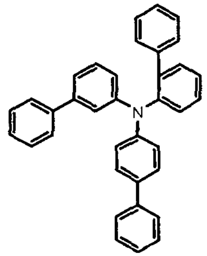 |
| M1-73 | M1-74 | M1-75 |
| 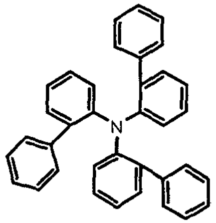 | 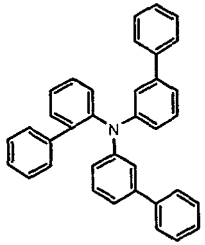 | 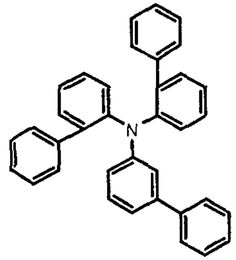 |
| M1-76 | M1-77 | M1-78 |
| 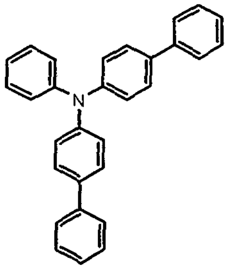 | 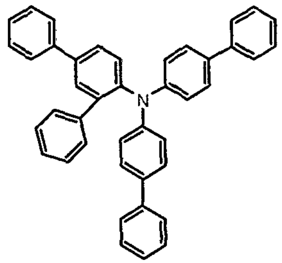 | 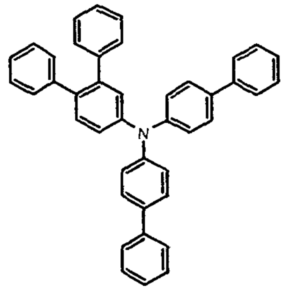 |
| M1-79 | M1-80 | M1-81 |

(fortgesetzt)

| | | |
|---|---|---|
| 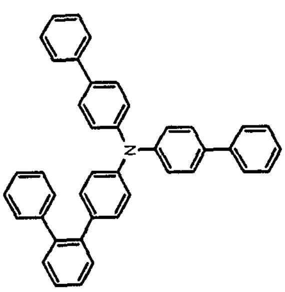 | 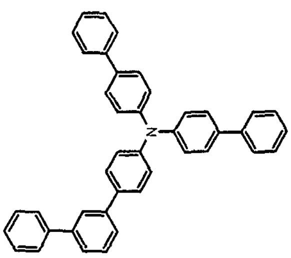 | 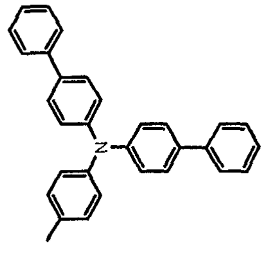 |
| M1-82 | M1-83 | M1-84 |
| 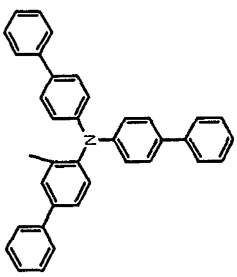 | 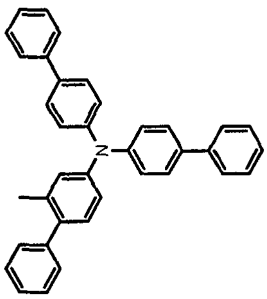 | 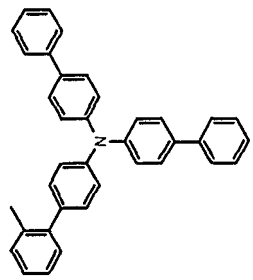 |
| M1-85 | M1-86 | M1-87 |
| 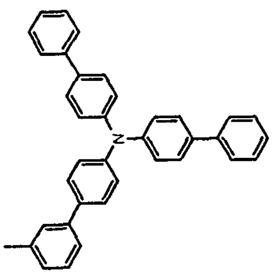 | 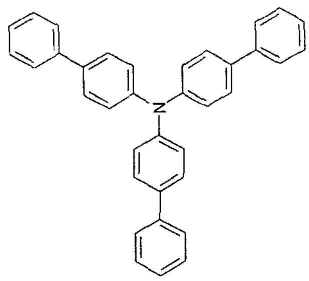 | 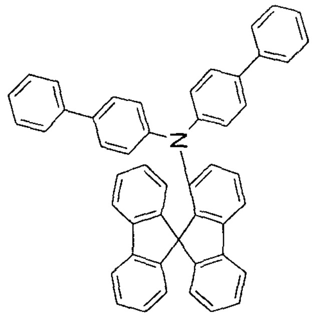 |
| M1-88 | M1-89 | M1-90 |

(fortgesetzt)

| | | |
|---|---|---|
| 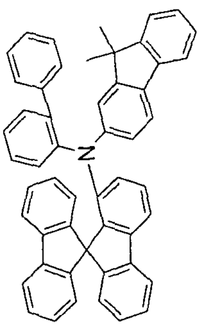 | 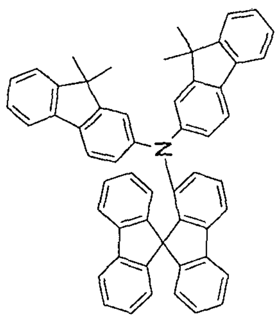 | 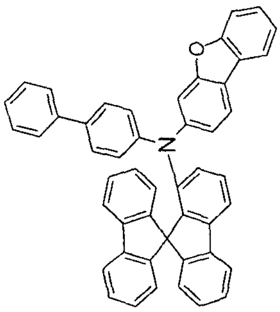 |
| M1-91 | M1-92 | M1-93 |
| 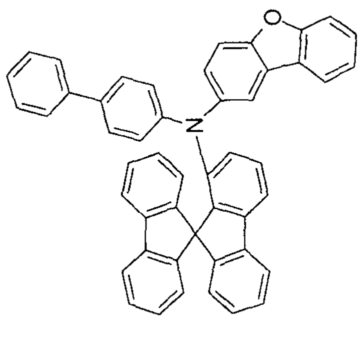 | 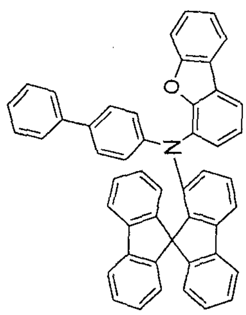 | 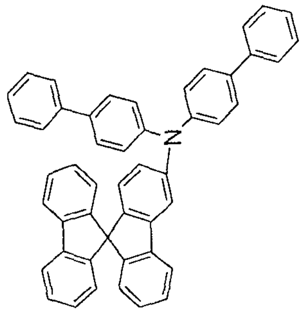 |
| M1-94 | M1-95 | M1-96 |
| 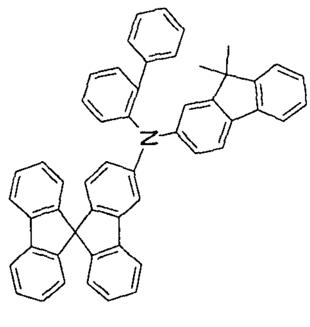 | 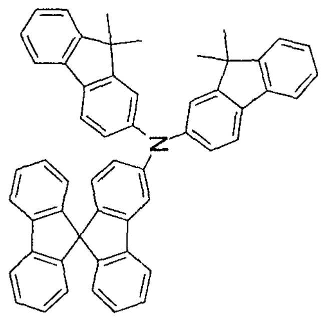 | 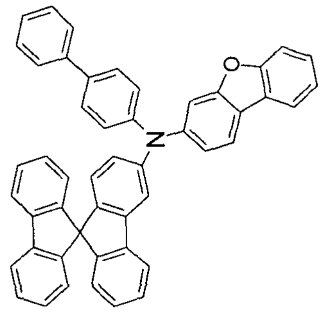 |
| M1-97 | M1-98 | M1-99 |

(fortgesetzt)

| | | | | | |
|---|---|---|---|---|---|
| 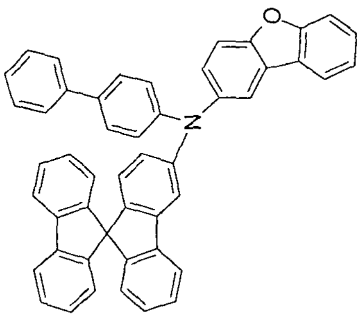 | M1-100 | 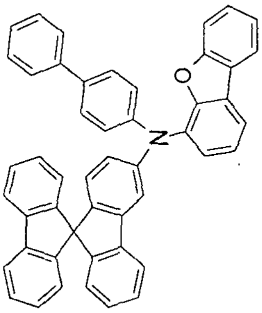 | M1-101 | 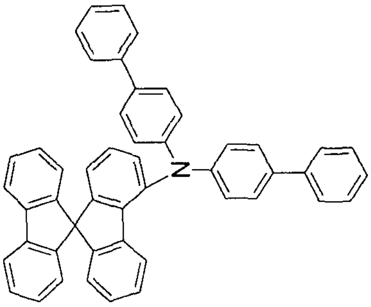 | M1-102 |
| 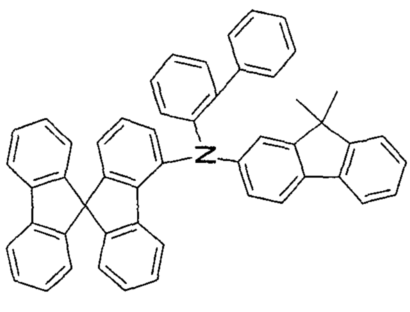 | M1-103 | 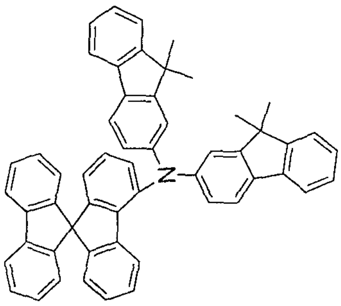 | M1-104 | 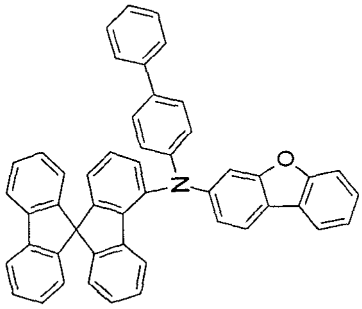 | M1-105 |

(fortgesetzt)

| | | |
|---|---|---|
| 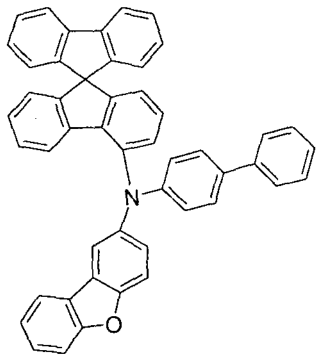 | 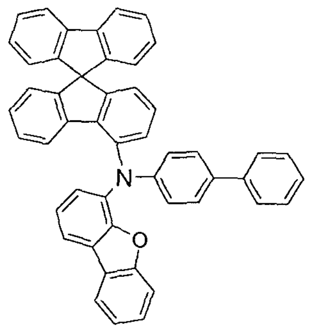 | 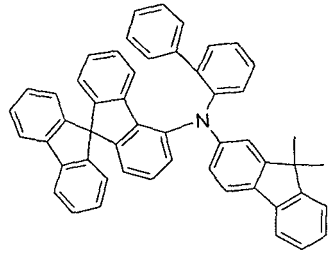 |
| M1-106 | M1-107 | M1-108 |
| 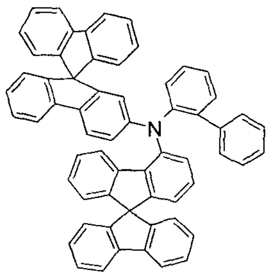 | 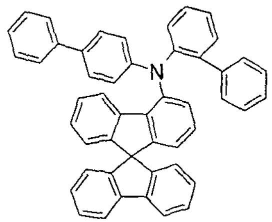 | 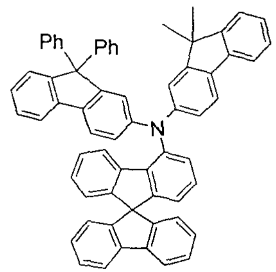 |
| M1-109 | M1-110 | M1-111 |
| 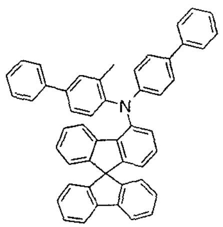 | 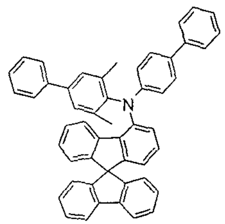 | 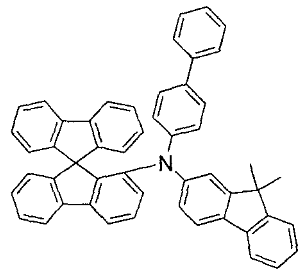 |
| M1-112 | M1-113 | M1-114 |

(fortgesetzt)

| | | | |
|---|---|---|---|
| 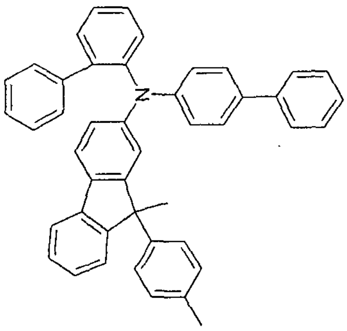 | M1-117 | 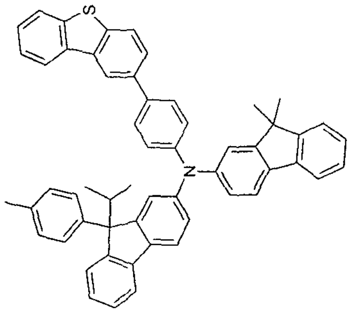 | M1-120 |
| 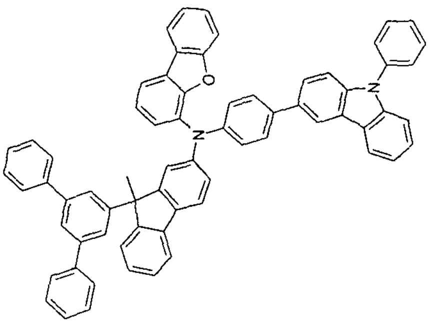 | M1-116 | 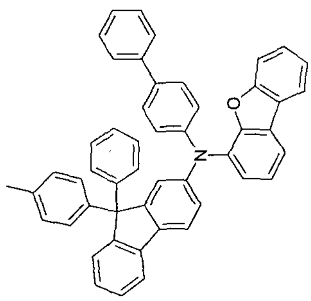 | M1-119 |
| 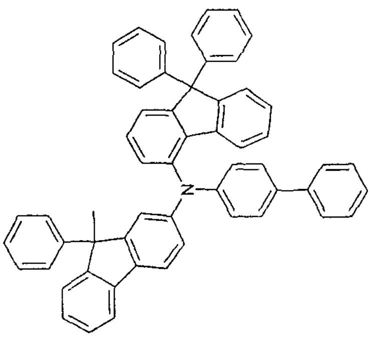 | M1-115 | 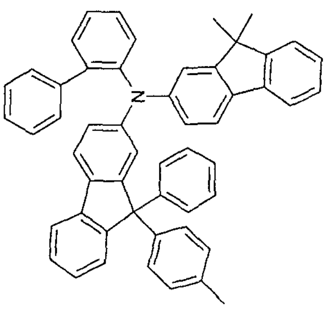 | M1-118 |

(fortgesetzt)

| | | |
|---|---|---|
| 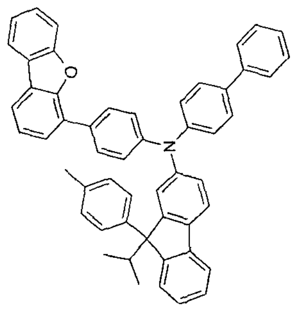 | 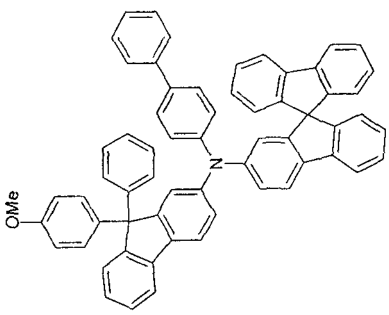 | 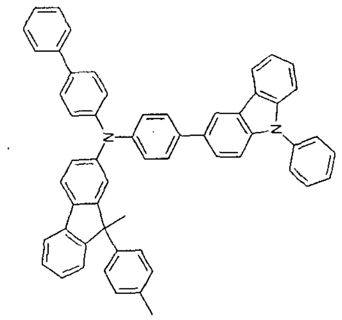 |
| M1-121 | M1-122 | M1-123 |
| 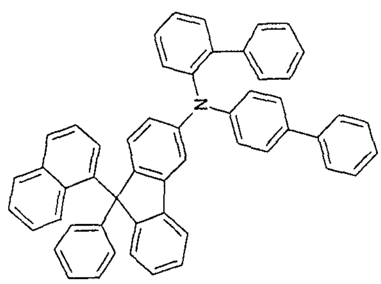 | 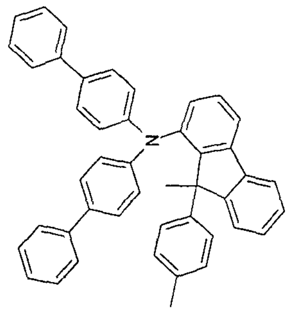 | 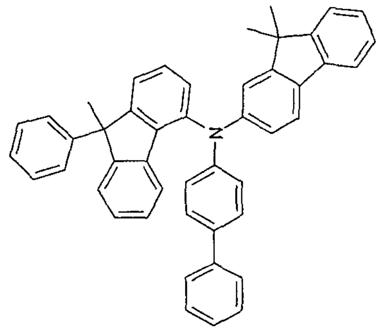 |
| M1-124 | M1-125 | M1-126 |

(fortgesetzt)

| | | |
|---|---|---|
| 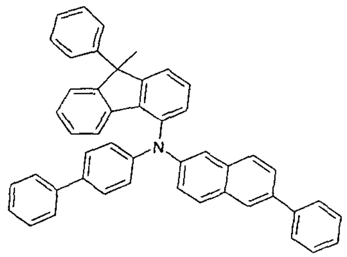 | 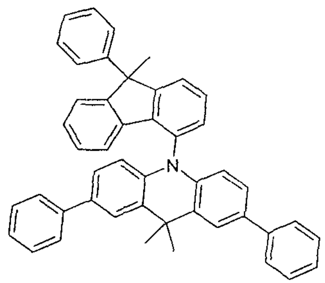 | 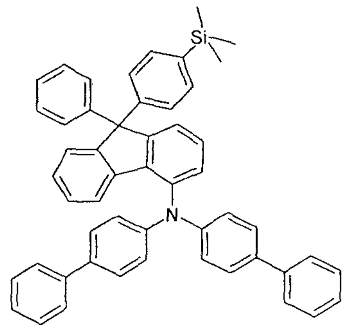 |
| M1-127 | M1-128 | M1-129 |
| 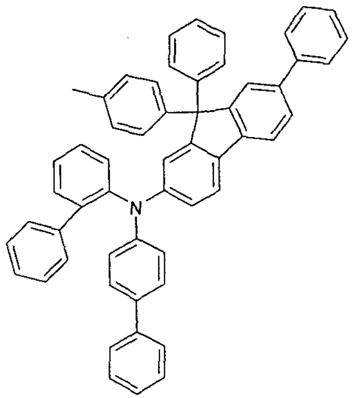 | 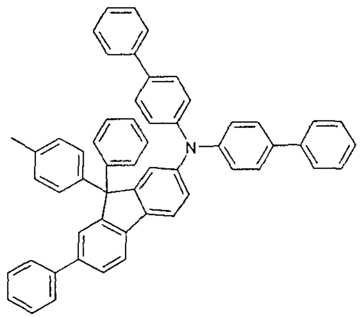 | 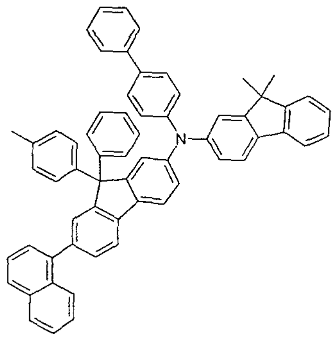 |
| M1-130 | M1-131 | M1-132 |

(fortgesetzt)

| | | |
|---|---|---|
| 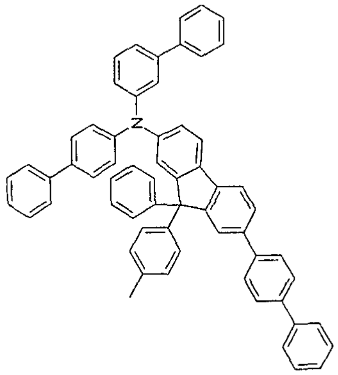 | 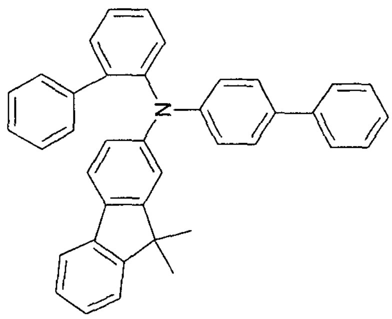 | 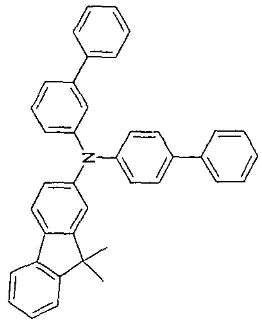 |
| M1-133 | M1-134 | M1-135 |
| 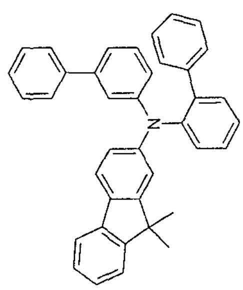 | 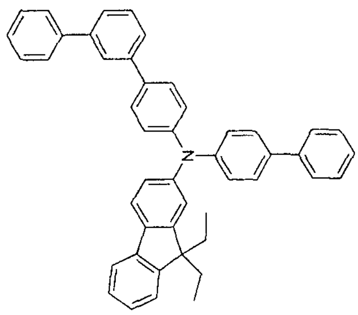 | 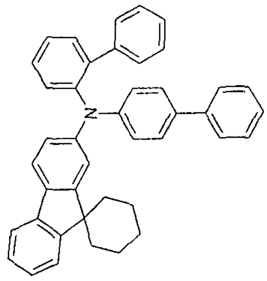 |
| M1-136 | M1-137 | M1-138 |

(fortgesetzt)

| | | |
|---|---|---|
| 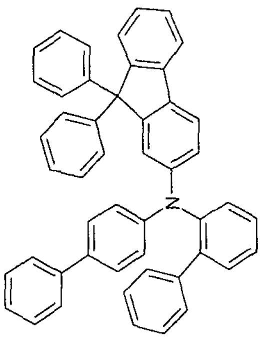 | 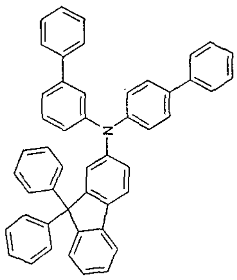 | 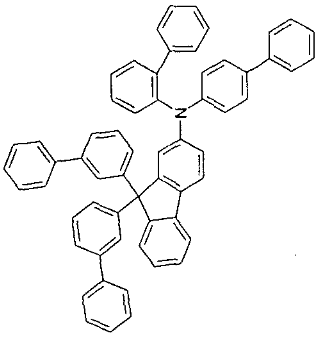 |
| M1-139 | M1-140 | M1-141 |
| 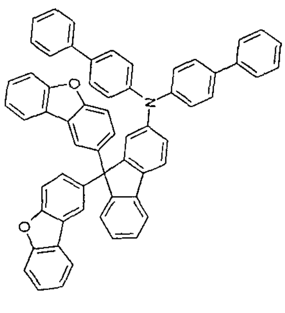 | 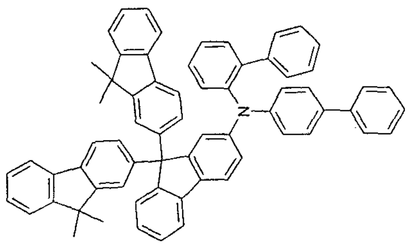 | 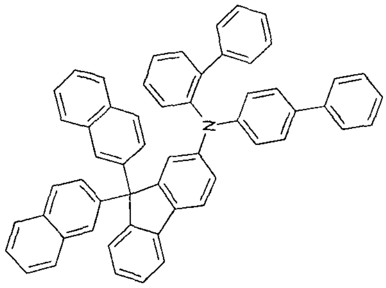 |
| M1-142 | M1-143 | M1-144 |

(fortgesetzt)

| | | |
|---|---|---|
| 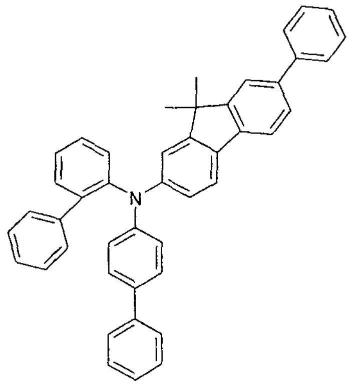 | 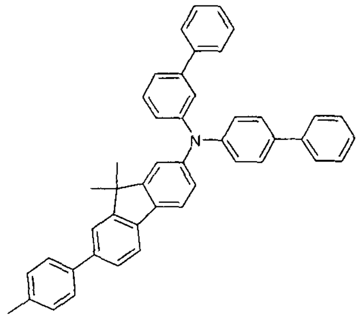 | 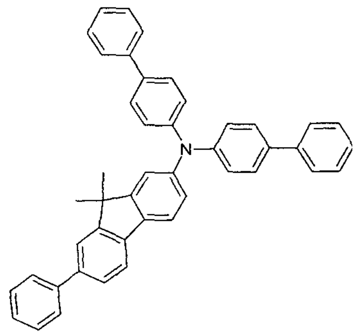 |
| M1-145 | M1-146 | M1-147 |
| 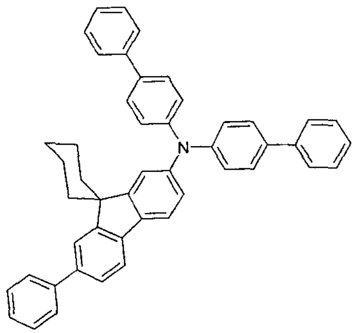 | 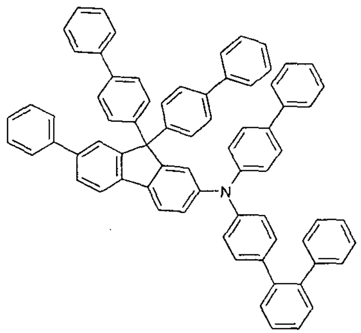 | 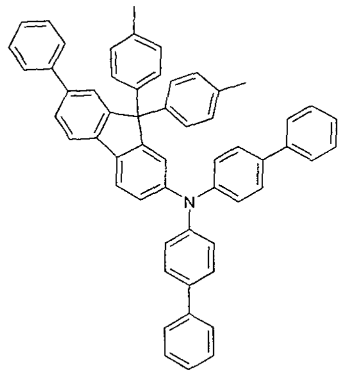 |
| M1-148 | M1-149 | M1-150 |

(fortgesetzt)

| | | |
|---|---|---|
| 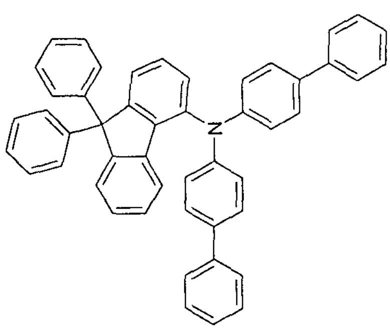 | 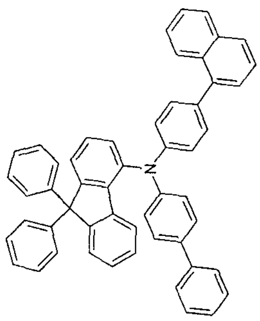 | 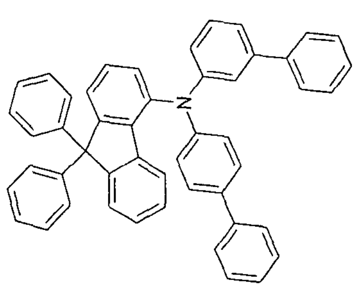 |
| M1-151 | M1-152 | M1-153 |
| 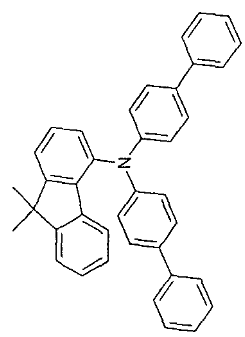 | 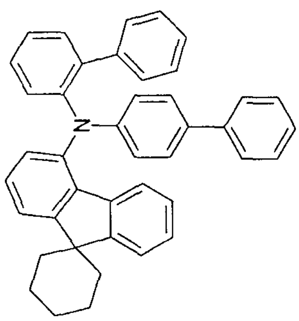 | 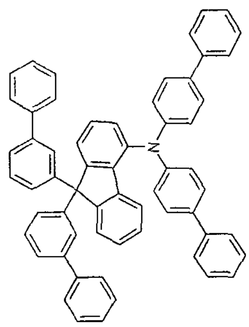 |
| M1-154 | M1-155 | M1-156 |

(fortgesetzt)

| | | |
|---|---|---|
| 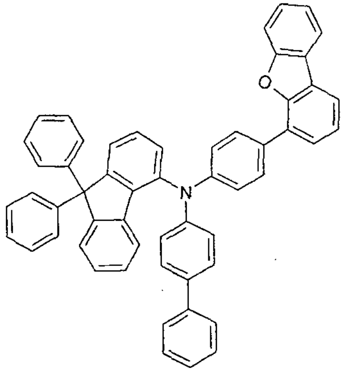 | 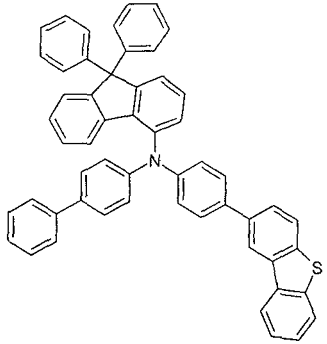 | 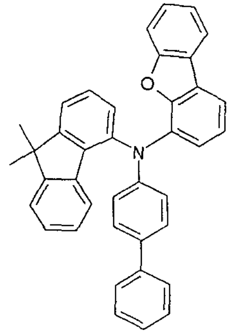 |
| M1-157 | M1-158 | M1-159 |
| 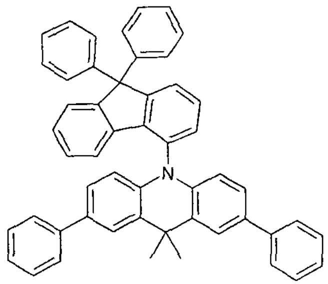 | 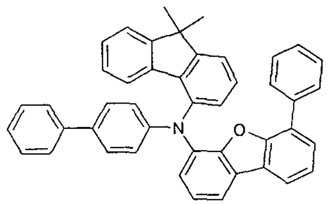 | 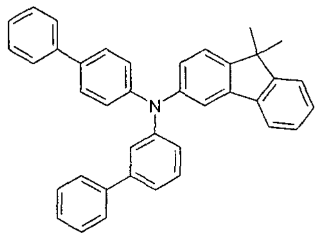 |
| M1-160 | M1-161 | M1-162 |
| 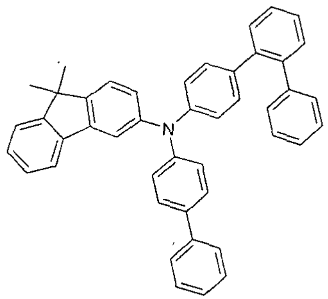 | 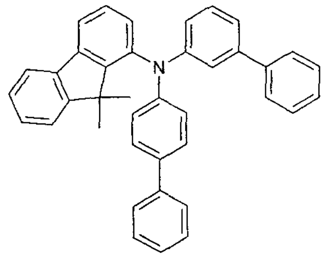 | 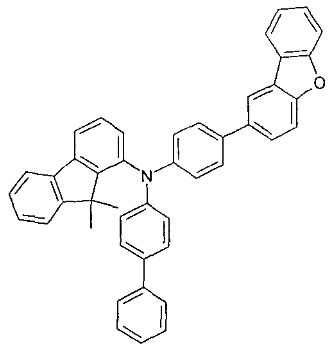 |

(fortgesetzt)

| M1-163 | M1-164 | M1-165 |
| --- | --- | --- |
| 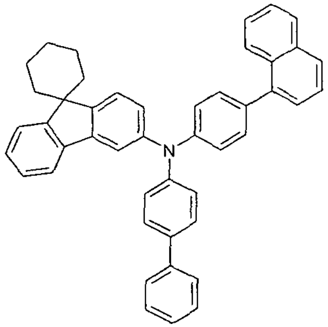 | 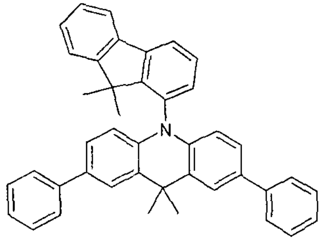 | 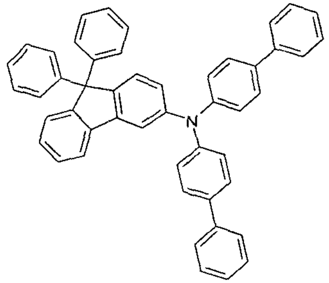 |
| M1-166 | M1-167 | M1-168 |
| 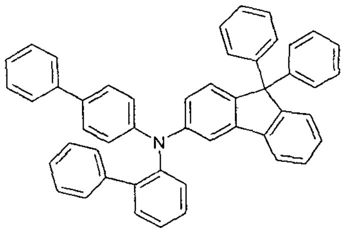 | 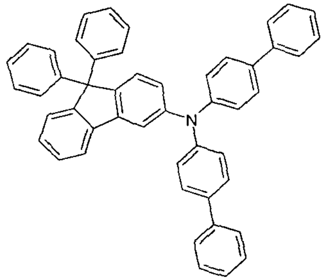 | 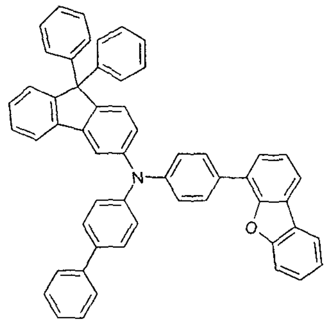 |
| M1-169 | M1-170 | M1-171 |

(fortgesetzt)

| | | |
|---|---|---|
| 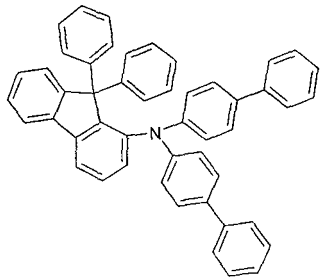 | 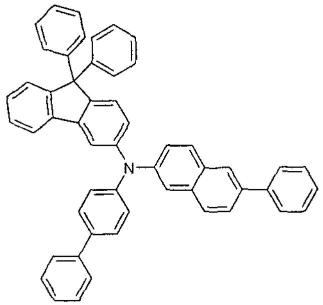 | 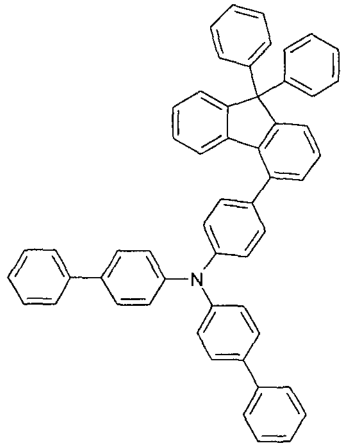 |
| M1-172 | M1-173 | M1-174 |
| 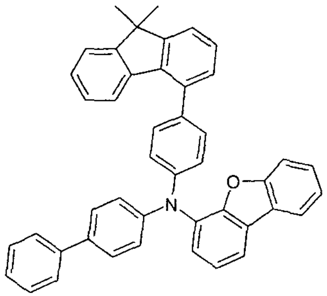 | 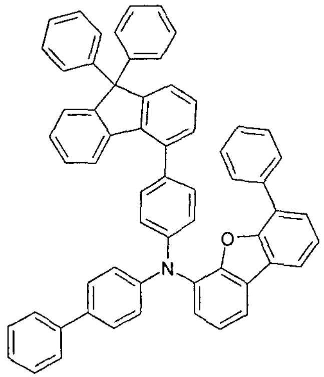 | 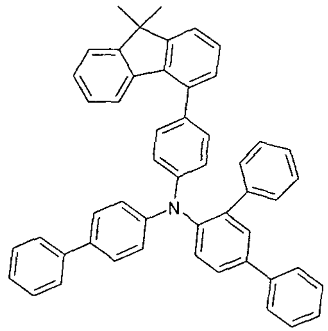 |
| M1-175 | M1-176 | M1-177 |

(fortgesetzt)

| | | | | | |
|---|---|---|---|---|---|
| 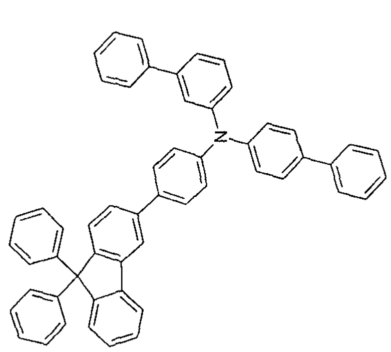 | M1-178 | 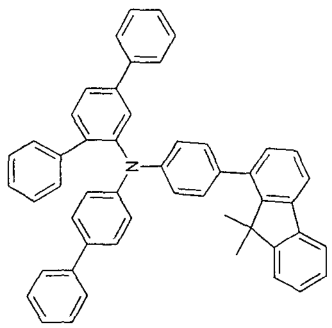 | M1-179 | 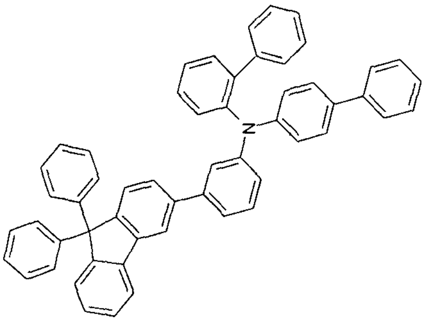 | M1-180 |
| 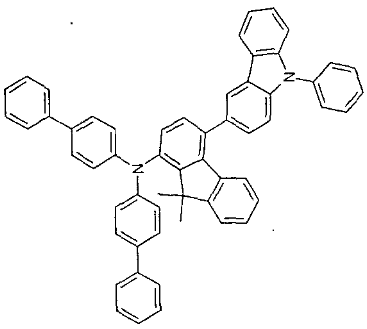 | M1-181 | 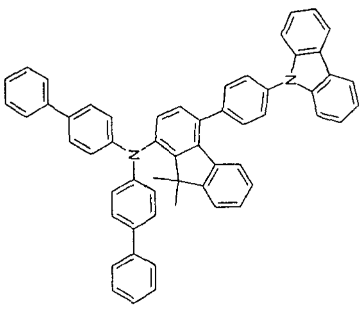 | M1-182 | 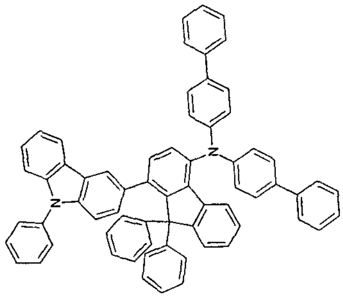 | M1-183 |

(fortgesetzt)

| | | |
|---|---|---|
| 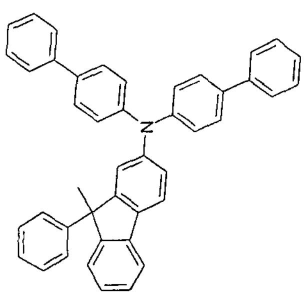 | 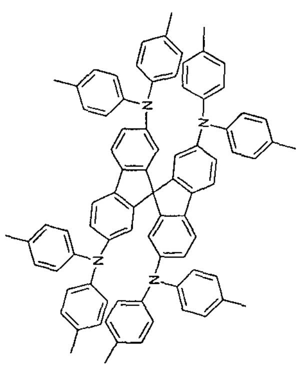 | 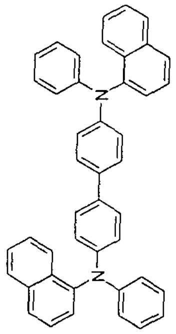 |
| M1-184 | M1-185 | M1-186 |
| 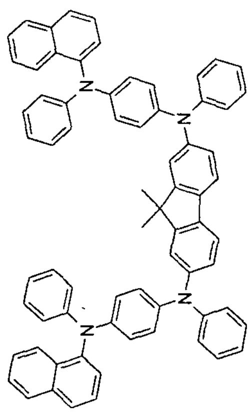 | 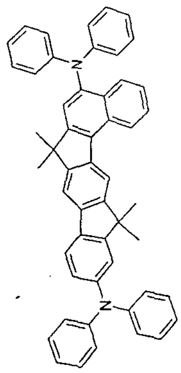 | |
| M1-187 | M1-188 | |
| 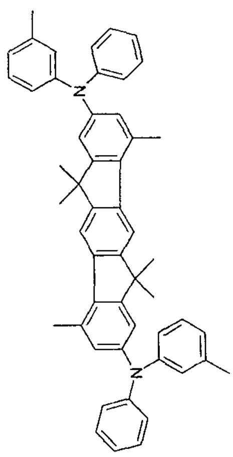 | 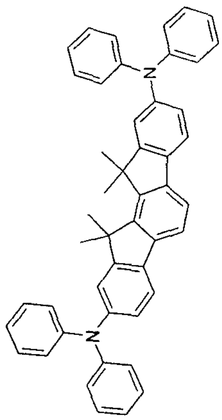 | |
| M1-189 | M1-190 | |

(fortgesetzt)

| | |
|---|---|
| 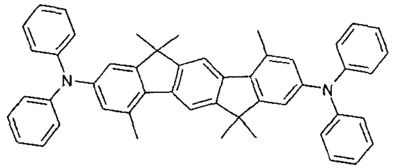 | 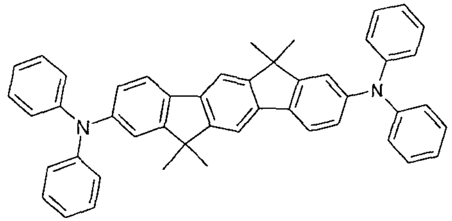 |
| M1-191 | M1-192 |
| 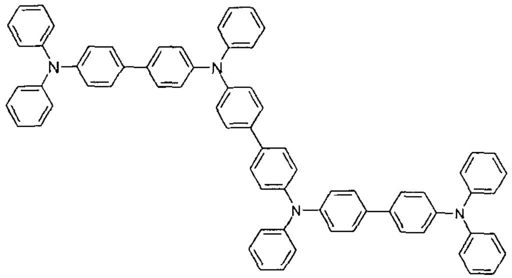 | 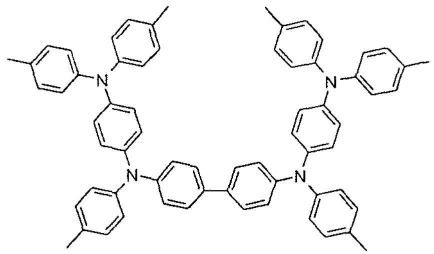 |
| M1-193 | M1-194 |
| 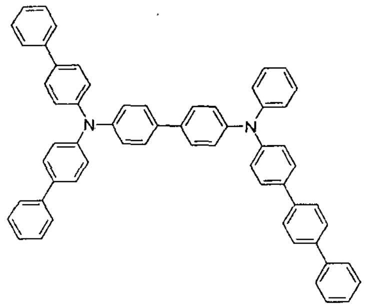 | 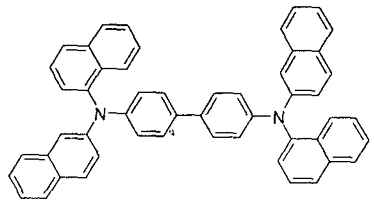 |
| M1-195 | M1-196 |

(fortgesetzt)

| | |
|---|---|
| 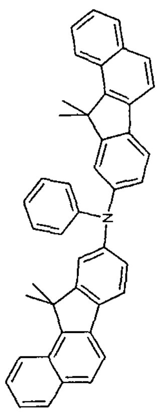 | 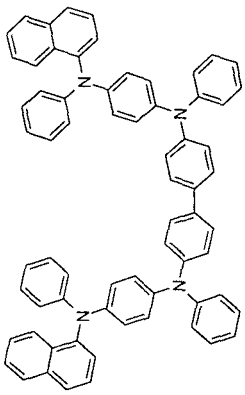 |
| M1-197 | M1-198 |
| 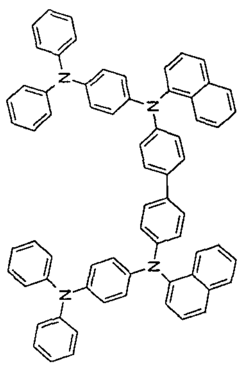 | 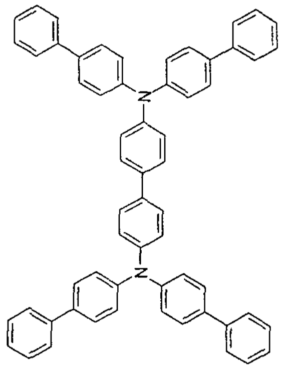 |
| M1-199 | M1-200 |
| 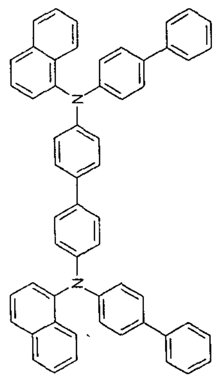 | 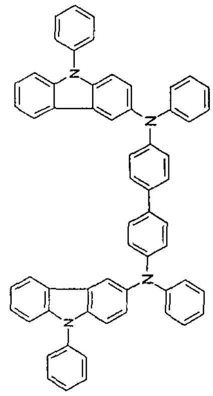 |
| M1-201 | M1-202 |

(fortgesetzt)

| | |
|---|---|
| 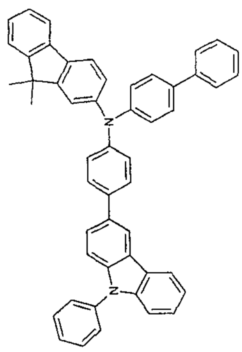 | 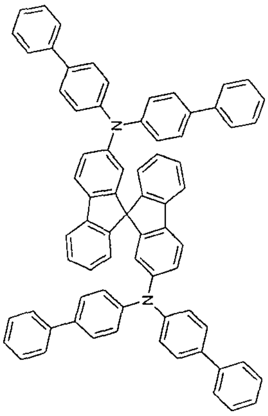 |
| M1-203 | M1-204 |
| 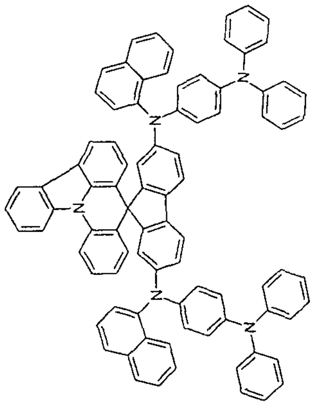 | |
| M1-205 | |

Bevorzugt liegt das HOMO des Matrixmaterials M1 zwischen 7.0 eV und -3.8 eV, bevorzugt zwischen -6.0 eV und -4.0 eV und besonders bevorzugt zwischen -5.5 eV und -5.0 eV.

Gemäß einer bevorzugten Ausführungsform der Erfindung ist das Matrixmaterial M2 ein kleines organisches Molekül. Bevorzugt ist es kein Polymer, Dendrimer oder Oligomer. Bevorzugt weist es ein Molekulargewicht von 200 bis 2000 g/mol, besonders bevorzugt 250 bis 1500 g/mol und ganz besonders bevorzugt von 300 bis 1000 g/mol auf.

Das Matrixmaterial M2 ist bevorzugt eine Verbindung enthaltend mindestens eine Anthraceneinheit. Bevorzugt ist sie eine wahlweise mit einem oder mehreren Resten $R^5$ substituierte 9,10-Diarylanthracen-Verbindung.

Bevorzugt entspricht das Matrixmaterial M2 der folgenden Formel (III)

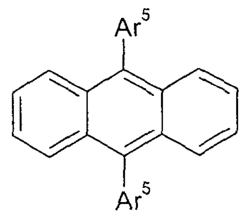

Formel (III), wobei gilt:

- $Ar^5$ ist bei jedem Auftreten gleich oder verschieden ein aromatisches oder heteroaromatisches Ringsystem mit 5 bis 40 aromatischen Ringatomen, das mit einem oder mehreren Resten $R^5$ substituiert sein kann; und

- $R^5$ ist bei jedem Auftreten gleich oder verschieden H, D, F, $C(=O)R^6$, CN, $Si(R^6)_3$, $N(R^6)_2$, $P(=O)(R^6)_2$, $S(=O)R^6$, $S(=O)_2R^6$, eine geradkettige Alkyl- oder Alkoxygruppe mit 1 bis 20 C-Atomen oder eine verzweigte oder cyclische Alkyl- oder Alkoxygruppe mit 3 bis 20 C-Atomen oder eine Alkenyl- oder Alkinylgruppe mit 2 bis 20 C-Atomen, wobei die oben genannten Gruppen jeweils mit einem oder mehreren Resten $R^6$ substituiert sein können und wobei eine oder mehrere $CH_2$-Gruppen in den oben genannten Gruppen durch $-R^6C=CR^6-$, -C≡C-, $Si(R^6)_2$, C=O, C=S, $C=NR^6$, -C(=O)O-, $-C(=O)NR^6-$, $NR^6$, $P(=O)(R^6)$, -O-, -S-, SO oder $SO_2$ ersetzt sein können und wobei ein oder mehrere H-Atome in den oben genannten Gruppen durch D, F oder CN ersetzt sein können, oder ein aromatisches oder heteroaromatisches Ringsystem mit 5 bis 30 aromatischen Ringatomen, das jeweils durch einen oder mehrere Reste $R^6$ substituiert sein kann, oder eine Aryloxy- oder Heteroaryloxygruppe mit 5 bis 30 aromatischen Ringatomen, die durch einen oder mehrere Reste $R^6$ substituiert sein kann, wobei zwei oder mehr Reste $R^5$ miteinander verknüpft sein können und einen Ring bilden können;

- $R^6$ ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten $R^6$ miteinander verknüpft sein und einen Ring bilden, und

das Anthracen kann an allen freien Positionen mit einer Gruppe $R^5$ substituiert sein.

$Ar^5$ ist bevorzugt bei jedem Auftreten gleich oder verschieden gewählt aus Arylgruppen mit 6 bis 18 aromatischen Ringatomen, bevorzugt 6 bis 14 aromatischen Ringatomen, die mit einem oder mehreren Resten $R^5$ substituiert sein können.

Besonders bevorzugt entspricht das Matrixmaterial M2 der Formel (III-1)

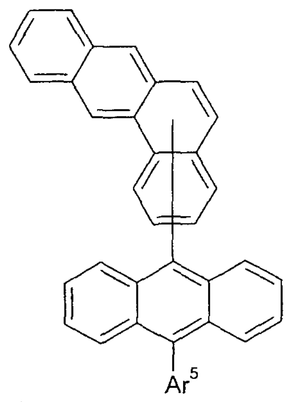

Formel (III-1),

wobei $Ar^5$ wie oben definiert ist und die Benzanthracenylgruppe in den Positionen 1, 2, 3, 4, 5 oder 6 an das Anthracen gebunden sein kann und das Benzanthracen und das Anthracen an allen freien Positionen mit einer Gruppe $R^5$ substituiert sein kann.

Im Rahmen der Anmeldung wird folgende Nummerierung des Benzanthracen-Grundgerüsts verwendet:

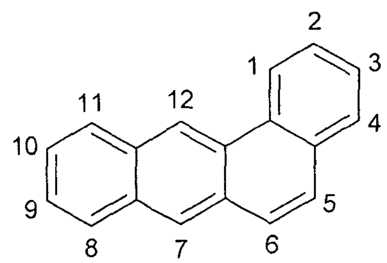

Weiterhin besonders bevorzugt entspricht das Matrixmaterial M2 der folgenden Formel (III-2)

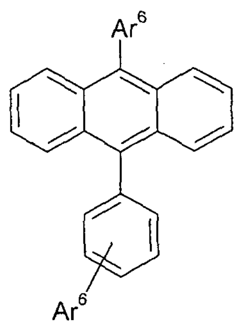

Formel (III-2), wo

wobei

$Ar^6$ bei jedem Auftreten gleich oder verschieden gewählt ist aus einer kondensierten Aryl- oder Heteroarylgruppe mit 10 bis 18 aromatischen Ringatomen, die mit einem oder mehreren Resten $R^5$ substituiert sein kann, und

die Anthracengruppe und die Phenylengruppe an allen freien Positionen mit einer Gruppe $R^5$ substituiert sein kann.

Bevorzugt ist $Ar^6$ gewählt aus Naphthyl-, Anthracenyl-, Pyrenyl- und Fluoranthenylgruppen, die mit einem oder mehreren Resten $R^5$ substituiert sein können.

Besonders bevorzugt als Matrixmaterialien M2 sind die in WO 2006/097208 offenbarten Ansa-Anthracene, die in WO 2006/131192 offenbarten Cycloalkyl-Aryl-Anthracene, die in WO 2007/065550 offenbarten Silyl-substituierten Anthracene, die in WO 2007/110129 offenbarten Tetraaryl-Anthracene, die in WO 2007/065678 offenbarten Bis-Anthracene, die in WO 2008/145239 offenbarten Benzanthracene, die in WO 2009/100925 offenbarten Phenanthryl-Anthracene, die in WO 2011/054442 offenbarten 9,10-Diarylanthracene, und die in EP 1553154 offenbarten 9,10-Diarylanthracene.

Beispiele für bevorzugte Matrixmaterialien M2 zur Verwendung in der erfindungsgemäßen elektronischen Vorrichtung sind in der folgenden Tabelle abgebildet.

| | | |
|---|---|---|
| 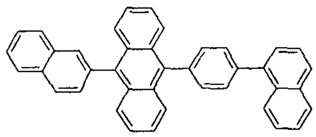 | 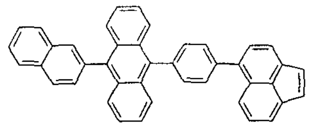 | 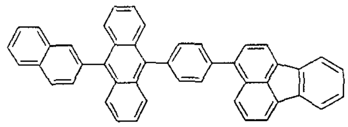 |
| M2-1 | M2-2 | M2-3 |
| 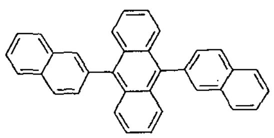 | 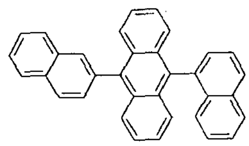 | 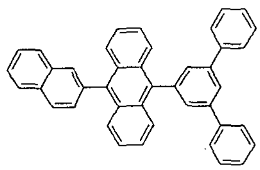 |
| M2-4 | M2-5 | M2-6 |
| 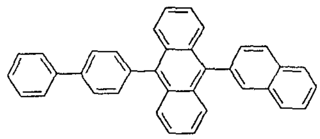 | 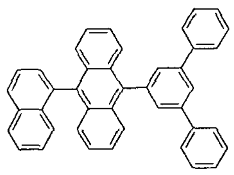 | 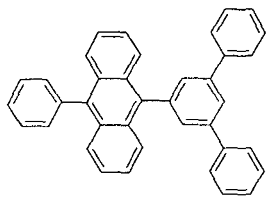 |
| M2-7 | M2-8 | M2-8 |
| 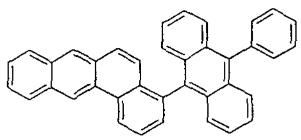 | 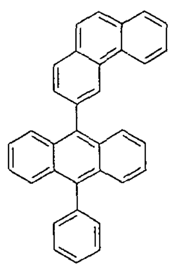 | 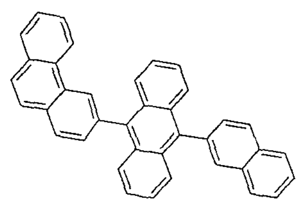 |
| M2-10 | M2-11 | M2-12 |
| 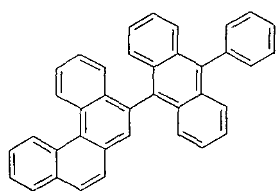 | 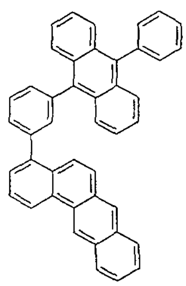 | 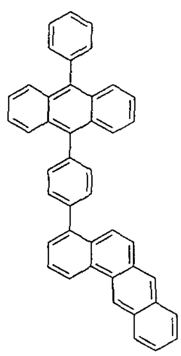 |
| M2-13 | M2-14 | M2-15 |

(fortgesetzt)

| | | |
|---|---|---|
| 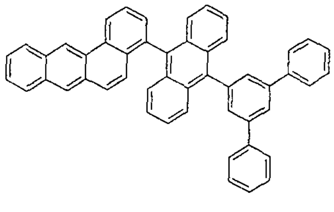 | 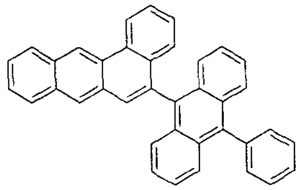 | 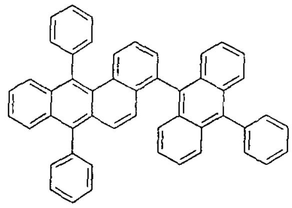 |
| M2-16 | M2-17 | M2-18 |
| 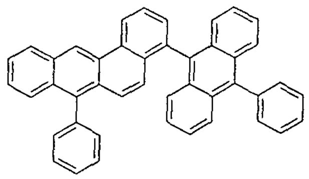 | 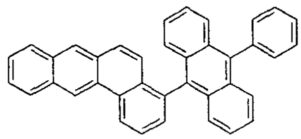 | 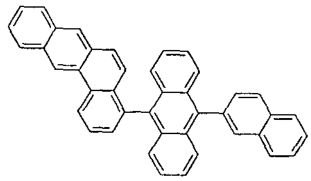 |
| M2-19 | M2-20 | M2-21 |
| 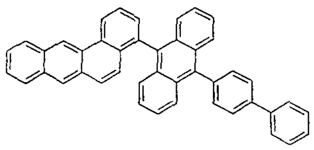 | 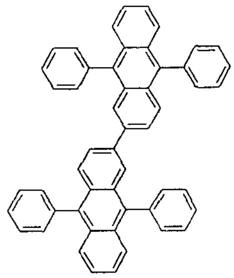 | 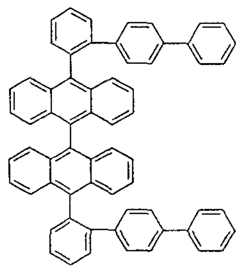 |
| M2-22 | M2-23 | M2-24 |
| 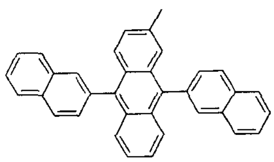 | 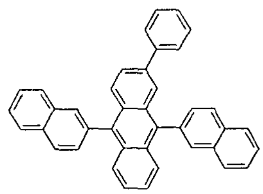 | 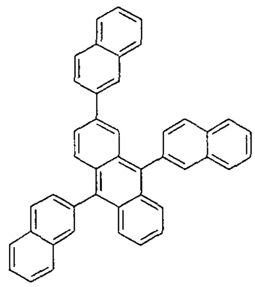 |
| M2-25 | M2-26 | M2-27 |
| 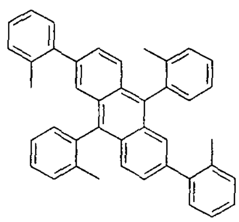 | 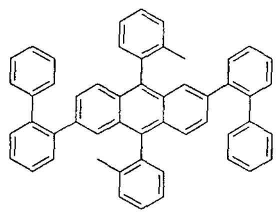 | 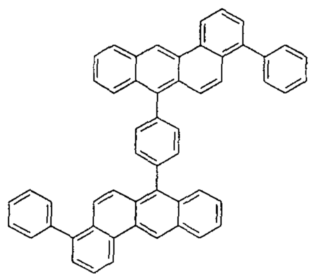 |
| M2-28 | M2-29 | M2-30 |

(fortgesetzt)

| | | |
|---|---|---|
| 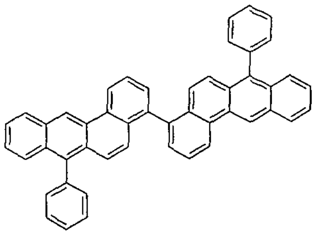 | 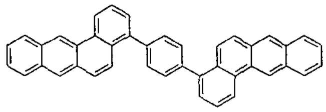 | 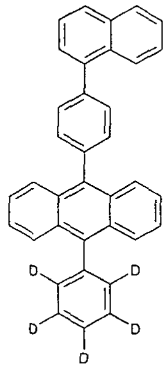 |
| M2-31 | M2-32 | M2-33 |
| 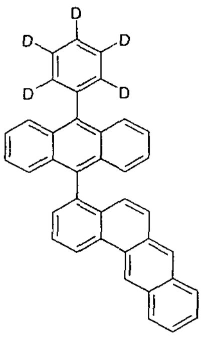 | 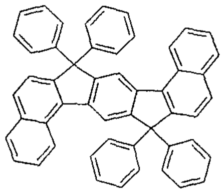 | 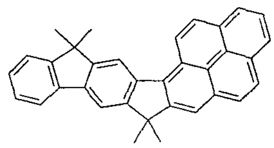 |
| M2-34 | M2-35 | M2-36 |
| 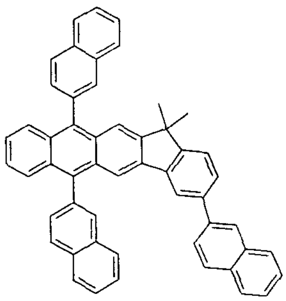 | 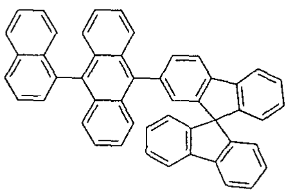 | 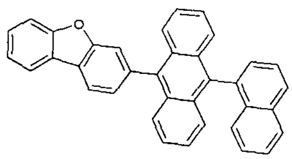 |
| M2-37 | M2-38 | M2-39 |
| 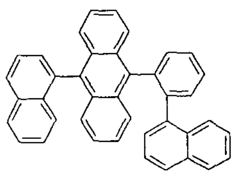 | 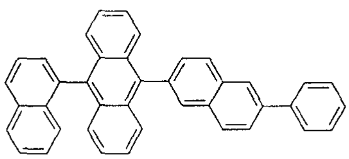 | 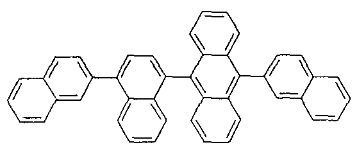 |
| M2-40 | M2-41 | M2-42 |
| 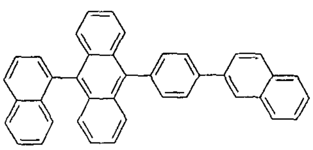 | 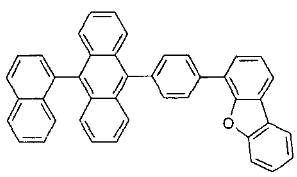 | 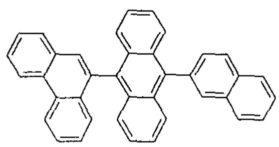 |
| M2-43 | M2-44 | M2-45 |

Gemäß einer bevorzugten Ausführungsform der Erfindung liegt das HOMO des Matrixmaterials M2 zwischen

-8.0 und -4.8 eV, besonders bevorzugt zwischen -6.5 und -5.0 eV, und ganz besonders bevorzugt zwischen -6.2 und -5.3 eV.

Gemäß einer bevorzugten Ausführungsform der Erfindung liegt das LUMO des Matrixmaterials M2 zwischen -4.0 und -2.3 eV, besonders bevorzugt zwischen -3.0 und -2.5 eV und ganz besonders bevorzugt zwischen -2.9 und -2.6 eV.

Erfindungsgemäß gilt für die HOMOs der Verbindungen E, M1 und M2: HOMO (M1) > HOMO (E) > HOMO (M2).

Der Abstand zwischen HOMO (M1) und HOMO (E) beträgt dabei bevorzugt mehr als 0.05 eV, besonders bevorzugt mehr als 0.08 eV und ganz besonders bevorzugt mehr als 0.1 eV.

Der Abstand zwischen HOMO (E) und HOMO (M2) beträgt dabei bevorzugt mehr als 0.05 eV, besonders bevorzugt mehr als 0.08 eV und ganz besonders bevorzugt mehr als 0.1 eV.

Weiterhin ist es erfindungsgemäß bevorzugt, dass das LUMO des Matrixmaterials M2 einen niedrigeren Wert aufweist als das LUMO des Matrixmaterials M1 und das LUMO der Emitterverbindung E.

Weiterer Gegenstand der Erfindung ist eine Formulierung, enthaltend mindestens ein organisches Lösungsmittel, mindestens eine Emitterverbindung E, mindestens ein Matrixmaterial M1 und mindestens ein Matrixmaterial M2, wobei die Emitterverbindung E gewählt ist aus Verbindungen enthaltend mindestens eine kondensierte Aryl- oder Heteroarylgruppe bestehend aus 2 bis 4 miteinander kondensierten aromatischen Ringen,
wobei das Matrixmaterial M2 gewählt ist aus Verbindungen enthaltend mindestens eine Anthraceneinheit,
und wobei für die HOMOs der Verbindungen E, M1 und M2 gilt: HOMO (M1) > HOMO (E) > HOMO (M2).

Bevorzugt sind in der Formulierung die Verbindungen E, M1 und M2 unterschiedlich gewählt.

Die Formulierung kann in einem Verfahren zur Herstellung einer elektronischen Vorrichtung verwendet werden. Insbesondere eignet sie sich zur Herstellung der emittierenden Schicht einer elektronischen Vorrichtung, bevorzugt einer OLED, durch Spin-Coating oder durch Druckverfahren. Wie solche Lösungen hergestellt werden können, ist dem Fachmann bekannt und beispielsweise in WO 2002/072714, WO 2003/019694 und der darin zitierten Literatur beschrieben.

Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis(3,4-Dimethylphenyl)ethan oder Mischungen dieser Lösemittel.

Für die erfindungsgemäße Formulierung gelten die oben angegebenen Bevorzugungen betreffend die Anteile der Verbindungen E, M1 und M2.

Weiterhin gelten für die erfindungsgemäße Formulierung die oben angegebenen bevorzugten Ausführungsformen für die Verbindungen E, M1 und M2.

Bevorzugt sind in der erfindungsgemäßen elektronischen Vorrichtung die Emitterverbindung E, das Matrixmaterial M1 und das Matrixmaterial M2 unterschiedlich gewählt.

Die Emitterverbindung E, das Matrixmaterial M1 und das Matrixmaterial M2 liegen erfindungsgemäß zusammen in der emittierenden Schicht vor, bevorzugt in homogener Mischung.

Neben den Verbindungen E, M1 und M2 können in der emittierenden Schicht weitere Verbindungen vorliegen, beispielsweise weitere Emitterverbindungen oder weitere Matrixmaterialien. Bevorzugt liegen solche Verbindungen in Anteilen von weniger als 10 Vol.-%, besonders bevorzugt weniger als 5 Vol.-% und ganz besonders bevorzugt weniger als 3 Vol.-% vor. Gemäß einer bevorzugten Ausführungsform enthält die erfindungsgemäße elektronische Vorrichtung in der emittierenden Schicht im Wesentlichen nur die Emitterverbindung E und die Matrixmaterialien M1 und M2. Weitere Verbindung sind in diesem Fall höchstens in Mengen von 1 Vol.-%, bevorzugt höchstens in Mengen von 0.5 Vol.-% und besonders bevorzugt höchstens in Mengen von 0.1 Vol.-% vorhanden.

Gemäß einer bevorzugten Ausführungsform liegt die Emitterverbindung E in der emittierenden Schicht in einem Anteil von 0.5 - 10 Vol.-%, besonders bevorzugt 1 - 8 Vol.-% und ganz besonders bevorzugt 2 - 6 Vol.-% vor.

Gemäß einer bevorzugten Ausführungsform liegt das Matrixmaterial M1 in der emittierenden Schicht in einem Anteil von 1 - 90 Vol.-%, besonders bevorzugt 3 - 60 Vol.-%, und ganz besonders bevorzugt 5 - 20 Vol.-% vor.

Gemäß einer weiteren bevorzugten Ausführungsform der Erfindung liegt das Matrixmaterial M1 in der emittierenden Schicht in einem Anteil von 7-16 Vol.-%, besonders bevorzugt in einem Anteil von 8-14 Vol.-% und ganz besonders bevorzugt in einem Anteil von 9-12 Vol.-% vor. Diese Ausführungsform hat den Vorteil, dass damit die Leistungsdaten der elektronischen Vorrichtung, insbesondere Lebensdauer und Effizienz, verbessert werden gegenüber der Verwendung von geringeren Mengen an Matrixmaterial M1.

Weiterhin bevorzugt emittiert die emittierende Schicht der erfindungsgemäßen elektronischen Vorrichtung Licht mit einem Emissionsmaximum bei einer Wellenlänge von 430 - 480 nm, bevorzugt 435 - 470 nm, besonders bevorzugt 440 - 460 nm.

Weiterhin bevorzugt emittiert die emittierende Schicht der erfindungsgemäßen elektronischen Vorrichtung Licht mit CIE-Koordinaten von $x<0.25$ und $y<0.35$, bevorzugt von $x<0.2$ und $y<0.3$. Weiterhin bevorzugt ist $x>0.1$ und $y>0$.

Weiterhin bevorzugt ist die erfindungsgemäße elektronische Vorrichtung gewählt aus organischen lichtemittierenden Transistoren (OLETs), organischen Solarzellen (OSCs), organischen optischen Detektoren, organischen Photorezeptoren, organischen Feld-Quench-Devices (OFQDs), organischen lichtemittierenden elektrochemischen Zellen (OLECs), organischen Laserdioden (O-Laser) und organischen Elektrolumineszenzvorrichtungen (OLEDs). Besonders bevorzugt ist sie gewählt aus organischen Elektrolumineszenzvorrichtungen.

Gemäß einer bevorzugten Ausführungsform der Erfindung weist die elektronische Vorrichtung, die bevorzugt gewählt ist aus organischen Elektrolumineszenzvorrichtungen, zusätzlich zur einen emittierenden Schicht, welche erfindungsgemäß die Verbindungen E, M1 und M2 enthält, mindestens eine weitere emittierende Schicht auf.

Gemäß einer bevorzugten Ausführungsform der Erfindung weist die elektronische Vorrichtung, die bevorzugt gewählt ist aus organischen Elektrolumineszenzvorrichtungen, mindestens eine Lochblockierschicht auf, die kathodenseitig in unmittelbarem Kontakt mit der emittierenden Schicht angeordnet ist. Unter einer Lochblockierschicht wird dabei eine elektronenleitende Schicht verstanden, welche sich zwischen emittierender Schicht und Kathode befindet, und welche lochblockierende Eigenschaften aufweist. Bevorzugt weist sie ein tiefliegendes HOMO auf. Bevorzugt weist sie zusätzlich ein tiefliegendes LUMO auf.

Gemäß einer bevorzugten Ausführungsform der Erfindung weist die elektronische Vorrichtung, die bevorzugt gewählt ist aus organischen Elektrolumineszenzvorrichtungen, mindestens eine Elektronenblockierschicht auf, die anodenseitig in unmittelbarem Kontakt mit der emittierenden Schicht angeordnet ist. Unter einer Elektronenblockierschicht wird dabei eine lochleitende Schicht verstanden, welche sich zwischen emittierender Schicht und Anode befindet, und welche elektronenblockierende Eigenschaften aufweist. Bevorzugt weist sie ein hochliegendes HOMO auf. Bevorzugt weist sie zusätzlich ein hochliegendes LUMO auf.

Die erfindungsgemäße elektronische Vorrichtung kann außer Kathode, Anode und der emittierenden Schicht noch weitere Schichten enthalten. Diese sind beispielsweise gewählt aus jeweils einer oder mehreren Lochinjektionsschichten, Lochtransportschichten, Lochblockierschichten, Elektronentransportschichten, Elektroneninjektionsschichten, Elektronenblockierschichten, Excitonenblockierschichten, Zwischenschichten (Interlayers), Ladungserzeugungsschichten (Charge-Generation Layers) (IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer) und/oder organischen oder anorganischen p/n-Übergängen. Es sei aber darauf hingewiesen, dass nicht notwendigerweise jede dieser Schichten vorhanden sein muss.

Die Abfolge der Schichten der elektronischen Vorrichtung ist bevorzugt die folgende:

> Anode-Lochinjektionsschicht-Lochtransportschicht-wahlweise zusätzliche Lochtransportschichten, bevorzugt eine, zwei oder drei zusätzliche Lochtransportschichten-emittierende Schicht-Elektronentransportschicht-Elektroneninjektionsschicht-Kathode.

Dabei soll erneut darauf hingewiesen werden, dass nicht alle der genannten Schichten vorhanden sein müssen, und/oder dass zusätzlich weitere Schichten vorhanden sein können. Gemäß einer bevorzugten Ausführungsform sind genau zwei zusätzliche Lochtransportschichten in oben genanntem Aufbau vorhanden. Gemäß einer weiteren bevorzugten Ausführungsform enthalten eine oder mehrere der Lochtransportschichten p-Dotanden. Als p-Dotanden werden in diesem Fall bevorzugt solche Verbindungen eingesetzt, die eine oder mehrere der anderen Verbindungen der Lochtransportschicht oxidieren können. Bevorzugt handelt es sich bei den p-Dotanden um organische Elektronenakzeptorverbindungen.

Besonders bevorzugte Ausführungsformen von p-Dotanden sind die in WO 2011/073149, EP 1968131, EP 2276085, EP 2213662, EP 1722602, EP 2045848, DE 102007031220, US 8044390, US 8057712, WO 2009/003455, WO 2010/094378, WO 2011/120709, US 2010/0096600 und WO 2012/095143 offenbarten Verbindungen.

Die erfindungsgemäße elektronische Vorrichtung kann blaues oder weißes oder andersfarbiges Licht emittieren, auch wenn die emittierende Schicht enthaltend die Verbindungen E, M1 und M2 blaues Licht emittiert. Dies kann dadurch erreicht werden, dass weitere emittierende Schichten und/oder Schichten vorhanden sind, die die Farbe des emittierten Lichts umwandeln.

Die erfindungsgemäße elektronische Vorrichtung kann eine oder mehrere weitere emittierende Schichten enthalten. Besonders bevorzugt weisen die emittierenden Schichten in diesem Fall insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können und die

blaues oder gelbes oder orangefarbenes oder rotes Licht emittieren. Bevorzugt sind Dreischichtsysteme, also Systeme mit drei emittierenden Schichten, wobei die drei Schichten blaue, grüne und orange oder rote Emission zeigen, oder Zweischichtsysteme, wobei die zwei Schichten blaue und orange Emission zeigen (für den prinzipiellen Aufbau siehe z. B. WO 2005/011013). Gemäß einer bevorzugten Ausführungsform ist dabei die blau emittierende Schicht eine fluoreszierende Schicht und die rot, orange, grün oder gelb emittierende(n) Schicht(en) sind phosphoreszierende Schichten.

Unter Fluoreszenz wird im Rahmen der vorliegenden Anmeldung Emission aus einem Übergang aus einem angeregten Singulett-Zustand verstanden. Unter Phosphoreszenz wird Emission aus einem spin-verbotenen Übergang verstanden, beispielsweise einem Übergang aus einem angeregten Triplettzustand oder einem Zustand mit einer höheren Spinquantenzahl, beispielsweise einem Quintett-Zustand.

Unter einer fluoreszierenden Schicht wird dabei eine Schicht enthaltend einen fluoreszierenden Emitter verstanden. Entsprechend wird unter einer phosphoreszierenden Schicht eine Schicht enthaltend einen phosphoreszierenden Emitter verstanden.

Als phosphoreszierende Emitter eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten. Bevorzugt werden als phosphoreszierende Dotanden Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium, Platin oder Kupfer enthalten.

Dabei werden im Sinne der vorliegenden Erfindung alle lumineszierenden Iridium-, Platin- oder Kupferkomplexe als phosphoreszierende Verbindungen angesehen. Beispiele der oben beschriebenen phosphoreszierenden Emitter können den Anmeldungen WO 2000/70655, WO 2001/41512, WO 2002/02714, WO 2002/15645, EP 1191613, EP 1191612, EP 1191614, WO 2005/033244, WO 2005/019373 und US 2005/0258742 entnommen werden.

Beispiele für fluoreszierende Emitter sind die oben als bevorzugte Ausführungsformen der Emitterverbindung E angegebenen Verbindungen.

Geeignete Ladungstransportmaterialien, wie sie in der Lochinjektions- bzw. Lochtransportschicht bzw. Elektronenblockierschicht oder in der Elektronentransportschicht der erfindungsgemäßen elektronischen Vorrichtung verwendet werden können, sind beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden.

Als Materialien für die Elektronentransportschicht können alle Materialien verwendet werden, wie sie gemäß dem Stand der Technik als Elektronentransportmaterialien in der Elektronentransportschicht verwendet werden. Insbesondere eignen sich Aluminiumkomplexe, beispielsweise $Alq_3$, Zirkoniumkomplexe, beispielsweise $Zrq_4$, Benzimidazolderviate, Triazinderivate, Pyrimidinderivate, Pyridinderivate, Pyrazinderivate, Chinoxalinderivate, Chinolinderivate, Oxadiazolderivate, aromatische Ketone, Lactame, Borane, Diazaphospholderivate und Phosphinoxidderivate. Weiterhin geeignete Materialien sind Derivate der oben genannten Verbindungen, wie sie in JP 2000/053957, WO 2003/060956, WO 2004/028217, WO 2004/080975 und WO 2010/072300 offenbart werden.

Bevorzugt sind als Lochtransportmaterialien, die in einer Lochtransport-, Lochinjektions- oder Elektronenblockierschicht in der erfindungsgemäßen Elektrolumineszenzvorrichtung verwendet werden können, Indenofluorenamin-Derivate (z. B. gemäß WO 06/122630 oder WO 06/100896), die in EP 1661888 offenbarten Aminderivate, Hexaazatriphenylenderivate (z. B. gemäß WO 01/049806), Aminderivate mit kondensierten Aromaten (z. B. gemäß US 5,061,569), die in WO 95/09147 offenbarten Aminderivate, Monobenzoindenofluorenamine (z. B. gemäß WO 08/006449), Dibenzoindenofluorenamine (z. B. gemäß WO 07/140847), Spirobifluoren-Amine (z. B. gemäß WO 2012/034627 oder WO 2013/120577), Fluoren-Amine (z. B. gemäß den noch nicht offengelegten Anmeldungen EP 12005369.9, EP 12005370.7 und EP 12005371.5), Spiro-Dibenzopyran-Amine (z. B. gemäß WO 2013/083216) und Dihydroacridin-Derivate (z. B. gemäß WO 2012/150001).

Als Kathode der elektronischen Vorrichtung sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag oder Al, wobei dann in der Regel Kombinationen der Metalle, wie beispielsweise Ca/Ag, Mg/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$, $BaF_2$, MgO, NaF, CsF, $Cs_2CO_3$, etc.). Weiterhin kann dafür Lithiumchinolinat (LiQ) verwendet werden. Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/$NiO_x$, Al/$PtO_x$) bevorzugt sein.

Für einige Anwendungen muss mindestens eine der Elektroden transparent oder teiltransparent sein, um entweder die Bestrahlung des organischen Materials (organische Solarzelle) oder die Auskopplung von Licht (OLED, O-LASER) zu ermöglichen. Bevorzugte Anodenmaterialien sind hier leitfähige gemischte Metalloxide. Besonders bevorzugt sind Indium-ZinnOxid (ITO) oder Indium-Zink Oxid (IZO). Bevorzugt sind weiterhin leitfähige, dotierte organische Materialien, insbesondere leitfähige dotierte Polymere. Weiterhin kann die Anode auch aus mehreren Schichten bestehen, beispielsweise aus einer inneren Schicht aus ITO und einer äußeren Schicht aus einem Metalloxid, bevorzugt Wolframoxid, Molybdänoxid oder Vanadiumoxid.

Die elektronische Vorrichtung wird entsprechend (je nach Anwendung) strukturiert, kontaktiert und schließlich versiegelt, da sich die Lebensdauer der erfindungsgemäßen Vorrichtungen bei Anwesenheit von Wasser und/oder Luft verkürzt.

In einer bevorzugten Ausführungsform ist die elektronische Vorrichtung dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Dabei ist es jedoch auch möglich, dass der Anfangsdruck noch geringer ist, beispielsweise kleiner $10^{-7}$ mbar.

Bevorzugt ist ebenfalls, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist, dass eine oder mehrere Schichten aus Lösung, wie z. B. durch Spincoating, oder mit einem beliebigen Druckverfahren, wie z. B. Siebdruck, Flexodruck, Nozzle Printing oder Offsetdruck, besonders bevorzugt aber LITI (Light Induced Thermal Imaging, Thermotransferdruck) oder Ink-Jet Druck (Tintenstrahldruck), hergestellt werden. Insbesondere ist es bevorzugt, dass die emittierende Schicht der erfindungsgemäßen Vorrichtung aus Lösung aufgetragen wird. Hierfür werden bevorzugt Formulierungen enthaltend die Verbindungen E, M1 und M2 verwendet, wie oben beschrieben.

Weiterhin bevorzugt ist es, dass zur Herstellung der elektronischen Vorrichtung eine oder mehrere Schichten aus Lösung und eine oder mehrere Schichten durch ein Sublimationsverfahren aufgetragen werden.

Gemäß einer bevorzugten Ausführungsform kann die erfindungsgemäße elektronische Vorrichtung in Displays, als Lichtquelle in Beleuchtungsanwendungen oder als Lichtquelle in medizinischen oder kosmetischen Anwendungen eingesetzt werden.

**Ausführungsbeispiele**

Die folgenden Ausführungsbeispiele dienen zur Erläuterung der Erfindung. Sie sind nicht einschränkend auszulegen.

**A) Messung der HOMO- und LUMO-Werte für Verbindungen zur Verwendung in der emittierenden Schicht**

Die HOMO- und LUMO-Lagen sowie das Triplett-Niveau der Materialien werden über quantenchemische Rechnungen bestimmt. Hierzu wird das Programmpaket "Gaussian03W" (Gaussian Inc.) verwendet. Zur Berechnung organischer Substanzen ohne Metalle wird zuerst eine Geometrieoptimierung mit der Methode "Ground State/Semiempirical/Default Spin/AM1/Charge 0/Spin Singlet" durchgeführt. Im Anschluss erfolgt auf Grundlage der optimierten Geometrie eine Energierechnung. Hierbei wird die Methode "TD-SFC/DFT/Default Spin/B3PW91" mit dem Basissatz "6-31G(d)" verwendet (Charge 0, Spin Singlet). Für metallorganische Verbindungen wird die Geometrie über die Methode "Ground State/ Hartree-Fock/Default Spin/LanL2MB/Charge 0/Spin Singlet" optimiert. Die Energierechnung erfolgt analog zu den organischen Substanzen, wie oben beschrieben, mit dem Unterschied, dass für das Metallatom der Basissatz "LanL2DZ" und für die Liganden der Basissatz "6-31G(d)" verwendet wird.

Aus der Energierechnung erhält man das HOMO HEh bzw. LUMO LEh in Hartree-Einheiten. Daraus werden die anhand von Cyclovoltammetriemessungen kalibrierten HOMO und LUMO Werte in Elektronenvolt wie folgt bestimmt:

$$\text{HOMO(eV)} = ((\text{HEh}*27.212)-0.9899)/1.1206$$

$$\text{LUMO(eV)} = ((\text{LEh}*27.212)-2.0041)/1.385$$

Diese Werte sind im Sinne dieser Anmeldung als HOMO bzw. LUMO der Materialien anzusehen. Zum Beispiel

erhält man aus der Rechnung ein HOMO von -0.19767 Hartrees und ein LUMO von -0.04783 Hartrees, was einem kalibrierten HOMO von -5.68346 eV und einem kalibrierten LUMO von -2.38675 eV entspricht.

In der folgenden Tabelle sind die ermittelten HOMO- und LUMO-Werte für die in den erfindungsgemäßen Verbindungen in der emittierenden Schicht verwendeten Verbindungen aufgeführt. Die Strukturen der Verbindungen sind in Tabelle 4 gezeigt. Die Verbindungen sind als solche zur Verwendung in OLEDs bekannt, und Verfahren zu ihrer Synthese sind im Stand der Technik beschrieben.

| Tabelle 1: HOMO- und LUMO-Werte der Materialien | | |
|---|---|---|
| Material | HOMO (eV) | LUMO (eV) |
| NPB | -5.19 | -2.34 |
| M1 | -5.56 | -2.70 |
| D1 | -5.34 | -2.79 |
| StA | -5.05 | -2.56 |
| TPB | -5.29 | -2.74 |
| MA1 | -5.25 | -2.18 |
| MA2 | -5.26 | -2.17 |

**B) Herstellung von OLEDs**

In den folgenden Beispielen V1 bis V5 und E1 bis E3 (siehe Tabelle 2 für Aufbau der Vorrichtungen und Tabelle 3 für erhaltene Messdaten der Vorrichtungen) werden die Ergebnisse verschiedener OLEDs vorgestellt.

Beispiele mit Buchstaben E und folgender Nummer bezeichnen dabei erfindungsgemäße Beispiele, Beispiele mit Buchstaben V und folgender Nummer bezeichnen Vergleichsbeispiele.

Glasplättchen, die mit strukturiertem ITO (Indium Zinn Oxid) der Dicke 50 nm beschichtet sind, werden nass gereinigt (Spülmaschine, Reiniger Merck Extran). Zunächst werden diese Glasplättchen mit einem UV-Ozon-Plasma behandelt und zur verbesserten Prozessierung eine 20 nm PEDOT:PSS-Schicht aufgebracht (Poly(3,4-ethylendioxythiophen)-poly(styrensulfonat), bezogen als CLEVIOS™ P VP AI 4083 von Heraeus Clevios Deutschland, aus wässriger Lösung aufgeschleudert). Die Glasplättchen bilden die Substrate, auf welche die OLEDs aufgebracht werden.

Die OLEDs haben prinzipiell folgenden Schichtaufbau: Substrat / HTL-Schichtenanordnung / Emissionsschicht (EML) / Elektronentransportschicht (ETL) / Elektroneninjektionsschicht (EIL) und abschließend eine Kathode. Die HTL-Schichtenanordnung besteht aus 140 nm SpA1, 5 nm HATCN und 20 nm MA1. Die Kathode wird durch eine 100 nm dicke Aluminiumschicht gebildet.

Der genaue Aufbau der OLEDs ist Tabelle 2 zu entnehmen. Die zur Herstellung der OLEDs benötigten Materialien sind in Tabelle 4 gezeigt.

Alle Materialien werden in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie M1:NPB:TPB (93%:5%:2%) bedeutet hierbei, dass das Material M1 in einem Volumenanteil von 93%, NPB in einem Anteil von 5% und TPB in einem Anteil von 2% in der Schicht vorliegt.

Die OLEDs werden standardmäßig charakterisiert. Hierfür werden die Elektrolumineszenzspektren, die Stromeffizienz (gemessen in cd/A), die Leistungseffizienz (gemessen in lm/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/$m^2$ bestimmt und daraus die CIE 1931 x und y Farbkoordinaten berechnet. Die Angabe U1000 in Tabelle 3 bezeichnet die Spannung, die für eine Leuchtdichte von 1000 cd/$m^2$ benötigt wird. SE1000 und LE1000 bezeichnen die Strom- bzw. Leistungseffizienz, die bei 1000 cd/$m^2$ erreicht werden. EQE1000 schließlich bezeichnet die externe Quanteneffizienz bei einer Betriebsleuchtdichte von 1000 cd/$m^2$. Als Lebensdauer LD wird die Zeit definiert, nach der die Leuchtdichte bei Betrieb mit konstantem Strom von der Startleuchtdichte L0 auf einen gewissen Anteil L1 absinkt. Eine Angabe von L0 = 6000 cd/$m^2$ und L1 = 70% in Tabelle 3 bedeutet, dass die in Spalte LD angegebene Lebensdauer der Zeit entspricht, nach der die Anfangsleuchtdichte von 6000 cd/$m^2$ auf 4200 cd/$m^2$ absinkt.

Die Daten der verschiedenen OLEDs sind in Tabelle 3 zusammengefasst. Die Vorrichtungen V1 bis V5 stellen dabei Vergleichsvorrichtungen dar, die Vorrichtungen E1 bis E3 stellen dabei elektronische Vorrichtungen gemäß der

vorliegenden Erfindung dar.

Die erhaltenen Daten zeigen, dass mit Emitterverbindungen (Verbindung D1), deren HOMO Lage sich zwischen denen der beiden Matrixmaterialien befindet, deutlich bessere Werte für Spannung, vor allem aber auch Effizienz und Lebensdauer erhalten werden, als dies bei Vergleichsvorrichtungen der Fall ist, die dieses Merkmal nicht aufweisen.

Beispielsweise zeigt Vorrichtung E1, bei der die Emitterverbindung ein HOMO aufweist, das zwischen den HOMOs der beiden Matrixmaterialien liegt, deutlich bessere Werte für Effizienz und Lebensdauer als Vorrichtung V3, bei der das HOMO des Emitters höher liegt als das HOMO beider Matrixmaterialien. Eine analoge Situation mit vergleichbaren Messergebnissen liegt für die Vorrichtung E2 gemäß der Erfindung verglichen mit Vorrichtung V4 vor.

Weiterhin zeigen die Beispiele, dass mit erfindungsgemäßen Vorrichtungen, die als Emitter eine Verbindung mit 2 bis 4 miteinander kondensierten aromatischen Ringen aufweisen, deutlich bessere Leistungsdaten (insbesondere Quanteneffizienz und Lebensdauer) erreicht werden als mit Vorrichtungen, die als Emitter eine Verbindung mit mehr als vier miteinander kondensierten aromatischen Ringen aufweisen (TBP).

Dies zeigt ein Vergleich der Daten für die erfindungsgemäßen Vorrichtungen E1 bis E3 mit den Vergleichsvorrichtungen V1, V2 und V5.

Tabelle 2: Aufbau der OLEDs

| Bsp. | EML Dicke | ETL Dicke | EIL Dicke |
|---|---|---|---|
| V1 | M1:NPB:TBP (93%:5%:2%) 30nm | ST1:LiQ (50%:50%) 20nm | LiQ 1nm |
| V2 | M1:MA1:TBP (91%:7%:2%) 30nm | ST1:LiQ (50%:50%) 20nm | LiQ 1 nm |
| V3 | M1:NPB:StA (90%:5%:5%) 30nm | ST1:LiQ (50%:50%) 20nm | LiQ 1nm |
| V4 | M1:MA1:StA (90%:5%:5%) 30nm | ST1:LiQ (50%:50%) 20nm | LiQ 1nm |
| V5 | M1:MA2:TBP (91%:7%:2%) 30nm | ST1:LiQ (50%:50%) 20nm | LiQ 1nm |
| E1 | M1:NPB:D1 (90%:5%:5%) 30nm | ST1:LiQ (50%:50%) 20nm | LiQ 1nm |
| E2 | M1:MA1:D1 (90%:5%:5%) 30nm | ST1:LiQ (50%:50%) 20nm | LiQ 1nm |
| E3 | M1:MA2:D1 (90%:7%:3%) 30nm | ST1:LiQ (50%:50%) 20nm | LiQ 1nm |

Tabelle 3: Daten der OLEDs

| Bsp. | U1000 (V) | SE1000 (cd/A) | LE1000 (lmlW) | EQE 1000 | CIE x/y bei 1000 $cd/m^2$ | L0 | L1 % | LD (h) |
|---|---|---|---|---|---|---|---|---|
| V1 | 4.5 | 9.2 | 4.5 | 6.0% | 0.14/0.21 | 6000 $cd/m^2$ | 70 | 130 |
| V2 | 4.3 | 10 | 7.2 | 6.7% | 0.14/0.20 | 6000 $cd/m^2$ | 70 | 180 |
| V3 | 4.8 | 6.7 | 4.4 | 6.0% | 0.15/0.15 | 6000 $cd/m^2$ | 70 | 60 |
| V4 | 4.4 | 6.9 | 4.9 | 6.1% | 0.14/0.15 | 6000 $cd/m^2$ | 70 | 100 |
| V5 | 4.4 | 9.9 | 7.1 | 6.9% | 0.14/0.20 | 6000 $cd/m^2$ | 70 | 195 |
| E1 | 4.5 | 6.2 | 4.3 | 6.4% | 0.15/0.10 | 6000 $cd/m^2$ | 70 | 180 |
| E2 | 4.3 | 7.7 | 5.6 | 7.9% | 0.14/0.10 | 6000 $cd/m^2$ | 70 | 240 |
| E3 | 4.4 | 7.6 | 5.4 | 7.8% | 0.14/0.10 | 6000 $cd/m^2$ | 70 | 260 |

Tabelle 4: Strukturformeln der verwendeten Materialien

| | |
|---|---|
| 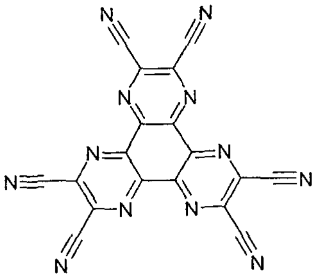 | 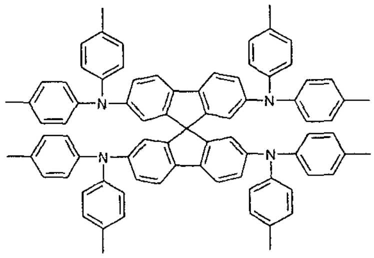 |
| HATCN | SpA1 |
| 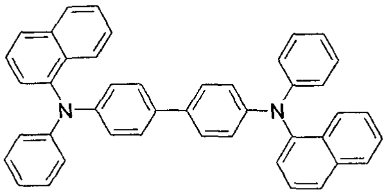 | 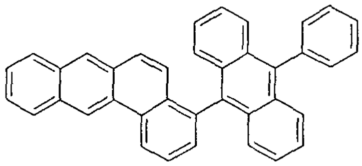 |
| NPB | M1 |
| 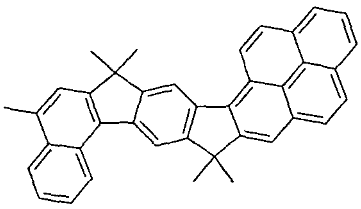 | 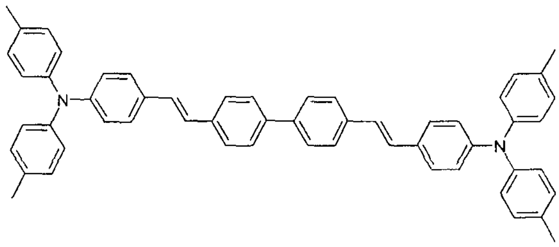 |
| D1 | StA |
| 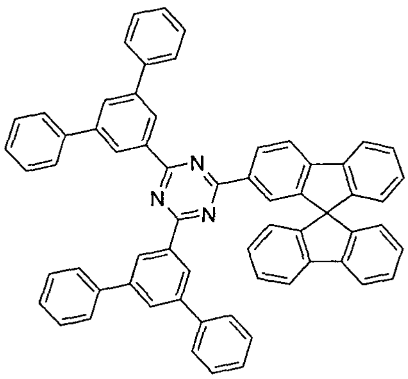 | 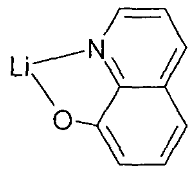 |
| ST1 | LiQ |
| 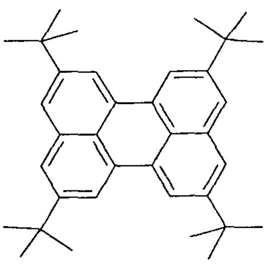 | 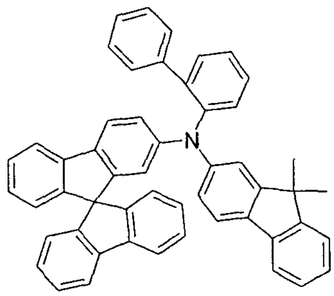 |
| TBP | MA1 |

(fortgesetzt)

| | |
|---|---|
| 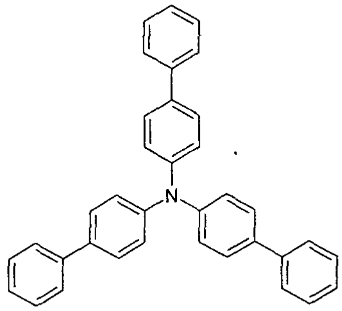 | |
| MA2 | |

## Patentansprüche

1. Elektronische Vorrichtung, enthaltend Anode, Kathode, sowie mindestens eine emittierende Schicht,
wobei die emittierende Schicht mindestens eine Emitterverbindung E, mindestens ein Matrixmaterial M1 und mindestens ein Matrixmaterial M2 enthält,
wobei die Emitterverbindung E gewählt ist aus Verbindungen enthaltend mindestens eine kondensierte Arylgruppe bestehend aus 2 bis 4 miteinander kondensierten aromatischen Ringen,
wobei das Matrixmaterial M2 gewählt ist aus Verbindungen enthaltend mindestens eine Anthraceneinheit,
und wobei für die HOMOs der Verbindungen E, M1 und M2 gilt: HOMO (M1) > HOMO (E) > HOMO (M2).

2. Elektronische Vorrichtung nach Anspruch 1, **dadurch gekennzeichnet, dass** die Emitterverbindung E eine fluoreszierende Verbindung ist.

3. Elektronische Vorrichtung nach Anspruch 1 oder 2, **dadurch gekennzeichnet, dass** die Emitterverbindung E keine Arylaminogruppe aufweist.

4. Elektronische Vorrichtung nach einem oder mehreren der Ansprüche 1 bis 3, **dadurch gekennzeichnet, dass** die Emitterverbindung E mindestens eine Gruppe gewählt aus Pyrenylgruppen, Anthracenylgruppen, Fluorenylgruppen und Indenofluorenylgruppen aufweist.

5. Elektronische Vorrichtung nach einem oder mehreren der Ansprüche 1 bis 4, **dadurch gekennzeichnet, dass** die Emitterverbindung E eine Verbindung der folgenden Formel (I) darstellt

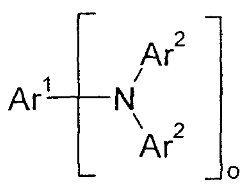

Formel (I), wobei

wobei gilt:

$Ar^1$ ist ein aromatisches oder heteroaromatisches Ringsystem mit 10 bis 40 aromatischen Ringatomen, enthaltend mindestens eine kondensierte Aryl- oder Heteroarylgruppe bestehend aus 2 bis 4 miteinander kondensierten aromatischen Ringen, wobei das aromatische oder heteroaromatische Ringsystem mit einem oder mehreren Resten $R^1$ substituiert sein kann;
$Ar^2$ ist ein aromatisches oder heteroaromatisches Ringsystem mit 6 bis 40 aromatischen Ringatomen, das mit einem oder mehreren Resten $R^1$ substituiert sein kann;
$R^1$ ist bei jedem Auftreten gleich oder verschieden H, D, F, $C(=O)R^2$, CN, $Si(R^2)_3$, $N(R^2)_2$, $P(=O)(R^2)_2$, $S(=O)R^2$,

$S(=O)_2R^2$, eine geradkettige Alkyl- oder Alkoxygruppe mit 1 bis 20 C-Atomen oder eine verzweigte oder cyclische Alkyl- oder Alkoxygruppe mit 3 bis 20 C-Atomen oder eine Alkenyl- oder Alkinylgruppe mit 2 bis 20 C-Atomen, wobei die oben genannten Gruppen jeweils mit einem oder mehreren Resten $R^2$ substituiert sein können und wobei eine oder mehrere $CH_2$-Gruppen in den oben genannten Gruppen durch $-R^2C=CR^2-$, $-C≡C-$, $Si(R^2)_2$, C=O, C=S, $C=NR^2$, -C(=O)O-, $-C(=O)NR^2-$, $NR^2$, $P(=O)(R^2)$, -O-, -S-, SO oder $SO_2$ ersetzt sein können und wobei ein oder mehrere H-Atome in den oben genannten Gruppen durch D, F oder CN ersetzt sein können, oder ein aromatisches oder heteroaromatisches Ringsystem mit 5 bis 30 aromatischen Ringatomen, das jeweils durch einen oder mehrere Reste $R^2$ substituiert sein kann, oder eine Aryloxy- oder Heteroaryloxygruppe mit 5 bis 30 aromatischen Ringatomen, die durch einen oder mehrere Reste $R^2$ substituiert sein kann, wobei zwei oder mehr Reste $R^1$ miteinander verknüpft sein können und einen Ring bilden können;

$R^2$ ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten $R^2$ miteinander verknüpft sein und einen Ring bilden; und

o ist 0, 1, 2, 3 oder 4.

6. Elektronische Vorrichtung nach Anspruch 5, **dadurch gekennzeichnet, dass** o gleich 0, 1 oder 2 ist.

7. Elektronische Vorrichtung nach Anspruch 5 oder 6, **dadurch gekennzeichnet, dass** $Ar^1$ gewählt ist aus folgenden Gruppen:

| | |
|---|---|
| 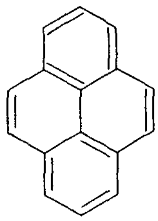 | 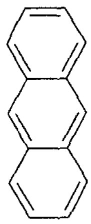 |
| $Ar^1$-1 | $Ar^1$-2 |
| | |
| 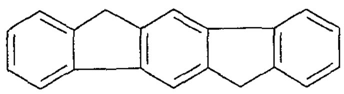 | 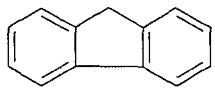 |
| $Ar^1$-3 | $Ar^1$-4 |
| 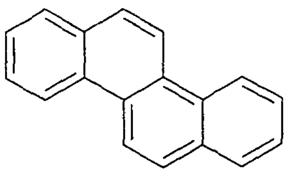 | 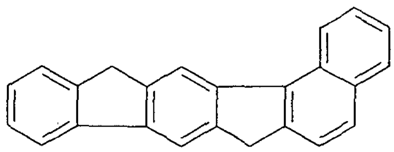 |
| $Ar^1$-5 | $Ar^1$-6 |
| | |
| 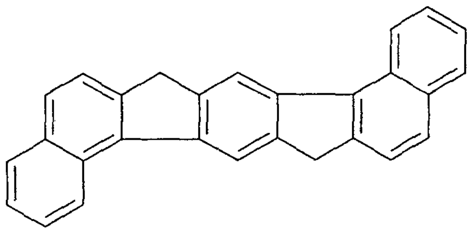 | |
| $Ar^1$-7 | |

wobei die Gruppen an allen freien Positionen mit einem oder mehreren Resten $R^1$ substituiert sein können, und

wobei die Gruppen der Formel $Ar^1$-3 und $Ar^1$-4 mindestens einen zusätzlichen ankondensierten aromatischen Ring aufweisen müssen, der an einen der Sechsringe ankondensiert ist.

8. Elektronische Vorrichtung nach 7, **dadurch gekennzeichnet, dass** die Gruppen der Formel $Ar^1$-3 und $Ar^1$-4 zwei oder drei zusätzliche ankondensierte aromatische Ringe aufweisen, die an einen einzigen oder an mehrere unterschiedliche Sechsringe ankondensiert sein können.

9. Elektronische Vorrichtung nach einem oder mehreren der Ansprüche 1 bis 8, **dadurch gekennzeichnet, dass** das Matrixmaterial M1 gewählt ist aus einer Mono-Triarylamino-Verbindung.

10. Elektronische Vorrichtung nach einem oder mehreren der Ansprüche 1 bis 9, **dadurch gekennzeichnet, dass** die Emitterverbindung E, das Matrixmaterial M1 und das Matrixmaterial M2 unterschiedlich gewählt sind.

11. Elektronische Vorrichtung nach einem oder mehreren der Ansprüche 1 bis 10, **dadurch gekennzeichnet, dass** das LUMO des Matrixmaterials M2 einen niedrigeren Wert aufweist als das LUMO des Matrixmaterials M1 und das LUMO der Emitterverbindung E.

12. Elektronische Vorrichtung nach einem oder mehreren der Ansprüche 1 bis 11, **dadurch gekennzeichnet, dass** das Matrixmaterial M1 in der emittierenden Schicht in einem Anteil von 1 - 90 Vol.-% vorhanden ist.

13. Elektronische Vorrichtung nach einem oder mehreren der Ansprüche 1 bis 12, gewählt aus organischen lichtemittierenden Transistoren (OLETs), organischen Solarzellen (OSCs), organischen optischen Detektoren, organischen Photorezeptoren, organischen Feld-Quench-Devices (OFQDs), organischen lichtemittierenden elektrochemischen Zellen (OLECs), organischen Laserdioden (O-Laser) und organischen Elektrolumineszenzvorrichtungen (OLEDs).

14. Elektronische Vorrichtung nach Anspruch 13, gewählt aus organischen Elektrolumineszenzvorrichtungen, **dadurch gekennzeichnet, dass** sie mindestens eine weitere emittierende Schicht aufweist.

15. Verwendung einer elektronischen Vorrichtung nach einem oder mehreren der Ansprüche 1 bis 14 in Displays, als Lichtquelle in Beleuchtungsanwendungen oder als Lichtquelle in medizinischen oder kosmetischen Anwendungen.

## Claims

1. Electronic device comprising anode, cathode, and at least one emitting layer,
where the emitting layer comprises at least one emitter compound E, at least one matrix material M1 and at least one matrix material M2, where the emitter compound E is selected from compounds containing at least one condensed aryl group consisting of 2 to 4 aromatic rings condensed with one another,
where the matrix material M2 is selected from compounds containing at least one anthracene unit,
and where the following applies to the HOMOs of compounds E, M1 and M2:

$$\text{HOMO (M1)} > \text{HOMO (E)} > \text{HOMO (M2)}.$$

2. Electronic device according to Claim 1, **characterised in that** the emitter compound E is a fluorescent compound.

3. Electronic device according to Claim 1 or 2, **characterised in that** the emitter compound E contains no arylamino group.

4. Electronic device according to one or more of Claims 1 to 3, **characterised in that** the emitter compound E contains at least one group selected from pyrenyl groups, anthracenyl groups, fluorenyl groups and indenofluorenyl groups.

5. Electronic device according to one or more of Claims 1 to 4, **characterised in that** the emitter compound E represents a compound of the following formula (I)

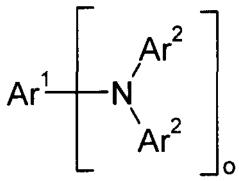

formula (I), wher

where:

$Ar^1$ is an aromatic or heteroaromatic ring system having 10 to 40 aromatic ring atoms, containing at least one condensed aryl or heteroaryl group consisting of 2 to 4 aromatic rings condensed with one another, where the aromatic or heteroaromatic ring system may be substituted by one or more radicals $R^1$;
$Ar^2$ is an aromatic or heteroaromatic ring system having 6 to 40 aromatic ring atoms, which may be substituted by one or more radicals $R^1$;
$R^1$ is on each occurrence, identically or differently, H, D, F, $C(=O)R^2$, CN, $Si(R^2)_3$, $N(R^2)_2$, $P(=O)(R^2)_2$, $S(=O)R^2$, $S(=O)_2R^2$, a straight-chain alkyl or alkoxy group having 1 to 20 C atoms or a branched or cyclic alkyl or alkoxy group having 3 to 20 C atoms or an alkenyl or alkynyl group having 2 to 20 C atoms, where the above-mentioned groups may each be substituted by one or more radicals $R^2$ and where one or more $CH_2$ groups in the above-mentioned groups may be replaced by - $R^2C=CR^2$-, -C≡C-, $Si(R^2)_2$, C=O, C=S, $C=NR^2$, -C(=O)O-, $-C(=O)NR^2-$, $NR^2$, $P(=O)(R^2)$, -O-, -S-, SO or $SO_2$ and where one or more H atoms in the above-mentioned groups may be replaced by D, F or CN, or an aromatic or heteroaromatic ring system having 5 to 30 aromatic ring atoms, which may in each case be substituted by one or more radicals $R^2$, or an aryloxy or heteroaryloxy group having 5 to 30 aromatic ring atoms, which may be substituted by one or more radicals $R^2$, where two or more radicals $R^1$ may be linked to one another and may form a ring;
$R^2$ is on each occurrence, identically or differently, H, D, F or an aliphatic, aromatic or heteroaromatic organic radical having 1 to 20 C atoms, in which, in addition, one or more H atoms may be replaced by D or F; two or more substituents $R^2$ here may be linked to one another and may form a ring; and
o is 0, 1, 2, 3 or 4.

6. Electronic device according to Claim 5, **characterised in that** o is equal to 0, 1 or 2.

7. Electronic device according to Claim 5 or 6, **characterised in that** $Ar^1$ is selected from the following groups:

| | |
|---|---|
| 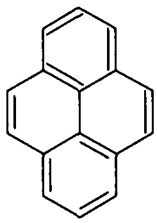 | 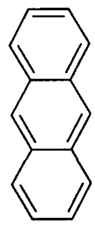 |
| $Ar^1$-1 | $Ar^1$-2 |
| | |
| 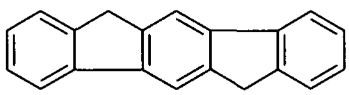 | 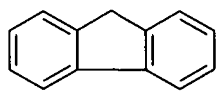 |
| $Ar^1$-3 | $Ar^1$-4 |

(continued)

| | |
|---|---|
| 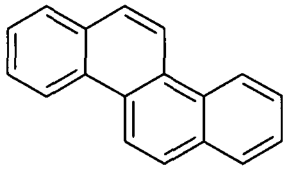 | 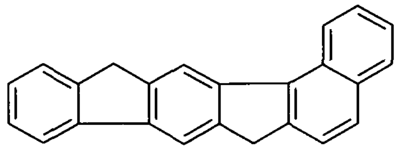 |
| $Ar^1$-5 | $Ar^1$-6 |
| | |
| 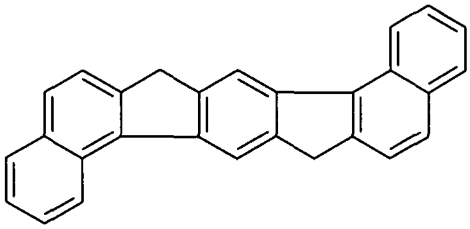 | |
| $Ar^1$-7 | |

where the groups may be substituted at all free positions by one or more radicals $R^1$, and
where the groups of the formula $Ar^1$-3 and $Ar^1$-4 must contain at least one additional condensed-on aromatic ring which is condensed onto one of the six-membered rings.

**8.** Electronic device according to 7, **characterised in that** the groups of the formula $Ar^1$-3 and $Ar^1$-4 contain two or three additional condensed-on aromatic rings, which can be condensed onto a single six-membered ring or onto a plurality of different six-membered rings.

**9.** Electronic device according to one or more of Claims 1 to 8, **characterised in that** the matrix material M1 is selected from a monotriarylamino compound.

**10.** Electronic device according to one or more of Claims 1 to 9, **characterised in that** the emitter compound E, the matrix material M1 and the matrix material M2 are selected differently.

**11.** Electronic device according to one or more of Claims 1 to 10, **characterised in that** the LUMO of the matrix material M2 has a lower value than the LUMO of the matrix material M1 and the LUMO of the emitter compound E.

**12.** Electronic device according to one or more of Claims 1 to 11, **characterised in that** the matrix material M1 is present in the emitting layer in a proportion of 1 - 90% by vol.

**13.** Electronic device according to one or more of Claims 1 to 12, selected from organic light-emitting transistors (OLETs), organic solar cells (OSCs), organic optical detectors, organic photoreceptors, organic field-quench devices (OFQDs), organic light-emitting electrochemical cells (OLECs), organic laser diodes (O-lasers) and organic electroluminescent devices (OLEDs).

**14.** Electronic device according to Claim 13, selected from organic electroluminescent devices, **characterised in that** it has at least one further emitting layer.

**15.** Use of an electronic device according to one or more of Claims 1 to 14 in displays, as light source in lighting applications or as light source in medical or cosmetic applications.

## Revendications

**1.** Dispositif électronique comprenant une anode, une cathode et au moins une couche d'émission,
dans lequel la couche d'émission comprend au moins un composé d'émetteur E, au moins un matériau de matrice

M1 et au moins un matériau de matrice M2,
dans lequel le composé d'émetteur E est sélectionné parmi les composés qui contiennent au moins un groupe aryle condensé qui est constitué par 2 à 4 cycles aromatiques qui sont condensés l'un avec l'autre ou les uns avec les autres,
dans lequel le matériau de matrice M2 est sélectionné parmi les composés qui contiennent au moins une unité anthracène,
et dans lequel ce qui suit s'applique aux HOMO de composés E, M1 et M2 :

HOMO (M1) > HOMO (E) > HOMO (M2).

2. Dispositif électronique selon la revendication 1, **caractérisé en ce que** le composé d'émetteur E est un composé fluorescent.

3. Dispositif électronique selon la revendication 1 ou 2, **caractérisé en ce que** le composé d'émetteur E ne contient pas de groupe arylamino.

4. Dispositif électronique selon une ou plusieurs des revendications 1 à 3, **caractérisé en ce que** le composé d'émetteur E contient au moins un groupe qui est sélectionné parmi les groupes pyrényle, les groupes anthracényle, les groupes fluorényle et les groupes indéno-fluorényle.

5. Dispositif électronique selon une ou plusieurs des revendications 1 à 4, **caractérisé en ce que** le composé d'émetteur E représente un composé de la formule (I) qui suit :

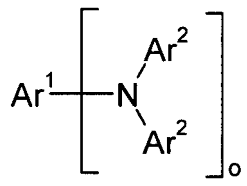

formule (I), dans

dans laquelle :

$Ar^1$ est un système de cycle aromatique ou hétéroaromatique qui comporte 10 à 40 atomes de cycle aromatique, qui contient au moins un groupe aryle ou hétéroaryle condensé qui est constitué par 2 à 4 cycles aromatiques condensés l'un avec l'autre ou les uns avec les autres, dans lequel le système de cycle aromatique ou hétéroaromatique peut être substitué par un radical ou plusieurs radicaux $R^1$ ;
$Ar^2$ est un système de cycle aromatique ou hétéroaromatique qui comporte 6 à 40 atomes de cycle aromatique, lequel peut être substitué par un radical ou plusieurs radicaux $R^1$ ;
$R^1$ est pour chaque occurrence, de manière identique ou différente, H, D, F, $C(=O)R^2$, CN, $Si(R^2)_3$, $N(R^2)_2$, $P(=O)(R^2)_2$, $S(=O)R^2$, $S(=O)_2R^2$, un groupe alkyle ou alcoxy en chaîne droite qui comporte 1 à 20 atome(s) de C ou un groupe alkyle ou alcoxy ramifié ou cyclique qui comporte 3 à 20 atomes de C ou un groupe alkényle ou alkynyle qui comporte 2 à 20 atomes de C, dans lequel les groupes qui ont été mentionnés ci-avant peuvent chacun être substitués par un radical ou plusieurs radicaux $R^2$ et dans lequel un ou plusieurs groupe(s) $CH_2$ dans les groupes qui ont été mentionnés ci-avant peut/peuvent être remplacé(s) par $-R^2C=CR^2-$, $-C\equiv C-$, $Si(R^2)_2$, C=O, C=S, $C=NR^2$, -C(=O)O-, $-C(=O)NR^2-$, $NR^2$, $P(=O)(R^2)$, -O-, -S-, SO ou $SO_2$ et dans lequel un ou plusieurs atome(s) de H dans les groupes qui ont été mentionnés ci-avant peut/peuvent être remplacé(s) par D, F ou CN, ou un système de cycle aromatique ou hétéroaromatique qui comporte 5 à 30 atomes de cycle aromatique, lequel peut dans chaque cas être substitué par un radical ou plusieurs radicaux $R^2$, ou un groupe aryloxy ou hétéroaryloxy qui comporte 5 à 30 atomes de cycle aromatique, lequel peut être substitué par un radical ou plusieurs radicaux $R^2$, où deux radicaux $R^1$ ou plus peuvent être liés l'un à l'autre ou les uns aux autres et peuvent former un cycle ;
$R^2$ est pour chaque occurrence, de manière identique ou différente, H, D, F ou un radical organique aromatique ou hétéroaromatique aliphatique qui comporte 1 à 20 atome(s) de C, où, en outre, un ou plusieurs atome(s) de H peut/peuvent être remplacé(s) par D ou F ; deux substituants $R^2$ ou plus peuvent ici être liés l'un à l'autre ou les uns aux autres et peuvent former un cycle ; et

o est 0, 1, 2, 3 ou 4.

**6.** Dispositif électronique selon la revendication 5, **caractérisé en ce que** o est égal à 0, 1 ou 2.

**7.** Dispositif électronique selon la revendication 5 ou 6, **caractérisé en ce que** $Ar^1$ est sélectionné parmi les groupes qui suivent :

| | |
|---|---|
| 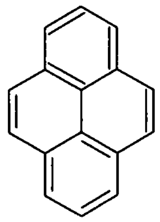 | 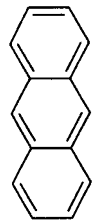 |
| $Ar^1$-1 | $Ar^1$-2 |
| 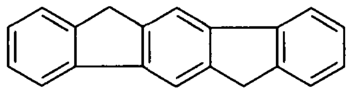 | 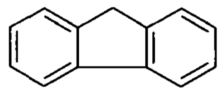 |
| $Ar^1$-3 | $Ar^1$-4 |
| | |
| 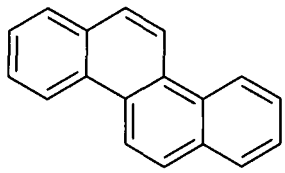 | 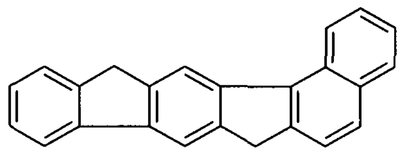 |
| $Ar^1$-5 | $Ar^1$-6 |
| | |
| 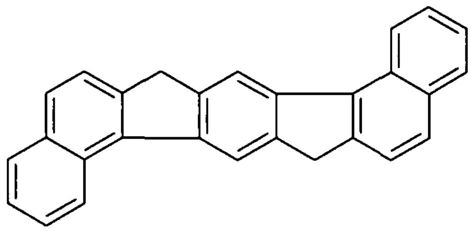 | |
| $Ar^1$-7 | |

où les groupes peuvent être substitués au niveau de toutes les positions libres par un radical ou plusieurs radicaux $R^1$ ; et
où les groupes des formules $Ar^1$-3 et $Ar^1$-4 doivent contenir au moins un cycle aromatique à condensation dessus additionnel qui est condensé sur l'un des cycles à six éléments.

**8.** Dispositif électronique selon la revendication 7, **caractérisé en ce que** les groupes des formules $Ar^1$-3 et $Ar^1$-4 contiennent deux ou trois cycles aromatiques à condensation dessus additionnels, lesquels peuvent être condensés sur un unique cycle à six éléments ou sur une pluralité de différents cycles à six éléments.

**9.** Dispositif électronique selon une ou plusieurs des revendications 1 à 8, **caractérisé en ce que** le matériau de matrice M1 est sélectionné parmi un composé monotriarylamino.

**10.** Dispositif électronique selon une ou plusieurs des revendications 1 à 9, **caractérisé en ce que** le composé d'émetteur E, le matériau de matrice M1 et le matériau de matrice M2 sont sélectionnés différemment.

**11.** Dispositif électronique selon une ou plusieurs des revendications 1 à 10, **caractérisé en ce que** le LUMO du matériau de matrice M2 présente une valeur plus faible que le LUMO du matériau de matrice M1 et que le LUMO du composé d'émetteur E.

**12.** Dispositif électronique selon une ou plusieurs des revendications 1 à 11, **caractérisé en ce que** le matériau de matrice M1 est présent dans la couche d'émission selon une proportion de 1 - 90 % en volume.

**13.** Dispositif électronique selon une ou plusieurs des revendications 1 à 12, sélectionné parmi les transistors à émission de lumière organiques (OLET), les cellules solaires organiques (OSC), les détecteurs optiques organiques, les photorécepteurs organiques, les dispositifs à extinction de champ organiques (OFQD), les cellules électrochimiques à émission de lumière organiques (OLEC), les diodes laser organiques (O-laser) et les dispositifs électroluminescents organiques (OLED).

**14.** Dispositif électronique selon la revendication 13, sélectionné parmi les dispositifs électroluminescents organiques, **caractérisé en ce qu'**il comporte au moins une autre couche d'émission.

**15.** Utilisation d'un dispositif électronique selon une ou plusieurs des revendications 1 à 14 dans des affichages, en tant que source de lumière dans des applications d'éclairage ou en tant que source de lumière dans des applications médicales ou cosmétiques.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4539507 A
- US 5151629 A
- EP 0676461 A
- WO 9827136 A
- US 4769292 A
- US 5908581 A
- US 5593788 A
- US 5141671 A
- EP 1227527 A
- US 7504163 B
- WO 2006108497 A
- WO 2007065678 A
- WO 2007140847 A
- WO 2008006449 A
- WO 2009127307 A
- WO 2010012328 A
- WO 2010049050 A
- EP 12006239 A
- WO 2006097208 A
- WO 2006131192 A
- WO 2007065550 A
- WO 2007110129 A
- WO 2008145239 A
- WO 2009100925 A
- WO 2011054442 A
- EP 1553154 A
- WO 2002072714 A
- WO 2003019694 A
- WO 2011073149 A
- EP 1968131 A
- EP 2276085 A
- EP 2213662 A
- EP 1722602 A
- EP 2045848 A
- DE 102007031220
- US 8044390 B
- US 8057712 B
- WO 2009003455 A
- WO 2010094378 A
- WO 2011120709 A
- US 20100096600 A
- WO 2012095143 A
- WO 2005011013 A
- WO 200070655 A
- WO 200141512 A
- WO 200202714 A
- WO 200215645 A
- EP 1191613 A
- EP 1191612 A
- EP 1191614 A
- WO 2005033244 A
- WO 2005019373 A
- US 20050258742 A
- JP 2000053957 A
- WO 2003060956 A
- WO 2004028217 A
- WO 2004080975 A
- WO 2010072300 A
- WO 06122630 A
- WO 06100896 A
- EP 1661888 A
- WO 01049806 A
- US 5061569 A
- WO 9509147 A
- WO 08006449 A
- WO 07140847 A
- WO 2012034627 A
- WO 2013120577 A
- EP 12005369 A
- EP 12005370 A
- EP 12005371 A
- WO 2013083216 A
- WO 2012150001 A


### In der Beschreibung aufgeführte Nicht-Patentliteratur


- **T. MATSUMOTO ; T. NAKADA ; J. ENDO ; K. MORI ; N. KAWAMURA ; A. YOKOI ; J. KIDO.** *Multiphoton Organic EL Device Having Charge Generation Layer,* 2003
- **Y. SHIROTA et al.** *Chem. Rev.,* 2007, vol. 107 (4), 953-1010
- **M. S. ARNOLD et al.** *Appl. Phys. Lett.,* 2008, vol. 92, 053301